(19) Europäisches Patentamt
European Patent Office
Office européen des brevets

(11) **EP 2 523 219 A1**

(12) **EUROPEAN PATENT APPLICATION**
published in accordance with Art. 153(4) EPC

(43) Date of publication:
**14.11.2012 Bulletin 2012/46**

(51) Int Cl.:
***H01L 31/04*** *(2006.01)* ***H01L 31/10*** *(2006.01)*

(21) Application number: **10842187.6**

(86) International application number:
**PCT/JP2010/072807**

(22) Date of filing: **17.12.2010**

(87) International publication number:
**WO 2011/083674 (14.07.2011 Gazette 2011/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.01.2010 JP 2010002352**

(71) Applicants:
• **Sharp Kabushiki Kaisha**
**Osaka-shi, Osaka 545-8522 (JP)**
• **Kyoto University**
**Sakyo-ku**
**Kyoto-shi**
**Kyoto 606-8501 (JP)**

(72) Inventors:
• **SHIGETA, Hiroaki**
**Osaka-shi,**
**Osaka 545-8522 (JP)**
• **YASHIRO, Yuhji**
**Osaka-shi,**
**Osaka 545-8522 (JP)**
• **TSUDA, Yuhsuke**
**Osaka-shi,**
**Osaka 545-8522 (JP)**
• **NODA, Susumu**
**Nishikyo-ku,**
**Kyoto-shi**
**Kyotot 615-8510 (JP)**
• **FUJITA, Masayuki**
**Nishikyo-ku,**
**Kyoto-shi**
**Kyotot 615-8510 (JP)**
• **TANAKA, Yoshinori**
**Nishikyo-ku,**
**Kyoto-shi**
**Kyotot 615-8510 (JP)**

(74) Representative: **Müller - Hoffmann & Partner**
**Patentanwälte**
**Innere Wiener Strasse 17**
**81667 München (DE)**

(54) **PHOTOELECTRIC TRANSDUCER**

(57)    A photoelectric transducer (10) including: a semiconductor layer (13); and a photonic crystal (21) formed inside the semiconductor layer, the photonic crystal being formed by providing nanorods (19) inside the semiconductor layer, each of the nanorods having a refractive index lower than that of a medium of the semiconductor layer, the nanorods being provided two-dimensionally and periodically at a pitch of not less than $\lambda/4$ nor more than $\lambda$, where $\lambda$ is a wavelength of a peak of resonance caused by the photonic crystal, the photoelectric transducer satisfying the following formula:

$$0.2Q_v \leq Q_a \leq 5.4Q_v$$

where $Q_v$ is (a) a Q value which indicates a magnitude of an effect of resonance caused by coupling between the photonic crystal and an external world and (b) in proportion to a reciprocal of a coefficient $\kappa_V$ indicating a strength of the coupling between the photonic crystal and the external world, and $Q_a$ is (a) a Q value which indicates a magnitude of an effect of resonance caused by the medium of the semiconductor layer and (b) in proportion to a reciprocal of a coefficient $\alpha_a$ of light absorption by the medium of the semiconductor layer. This allows an increase in light absorption ratio of a photoelectric transducer including a photonic crystal structure.

EP 2 523 219 A1

F I G. 1

**Description**

Technical Field

The present invention relates to a photoelectric transducer including a photonic crystalline structure.

Background Art

Currently, a photoelectric transducer that converts incident light into an electric signal by photoelectric conversion is in general use as, for example, a solar cell or an optical sensor. The photoelectric transducer employs a semiconductor. When an electromagnetic wave (light) having an energy exceeding a band gap of the semiconductor enters, an electron is excited from a valence band into a conduction band in the semiconductor, so that photoelectric conversion occurs.

For example, a-Si, which is an amorphous semiconductor, is generally known to absorb an electromagnetic wave with a wavelength of about 700 nm or less (a light absorption edge is around 700 nm). That is, in a case of an electromagnetic wave (light) having a wavelength shorter than the absorption edge, the light is absorbed by a photovoltaic material, so that photoelectric conversion occurs in the photovoltaic material. In an actual device, however, improvements of a processing method and a production method allow absorption of an electromagnetic wave (light) up to about 820 nm. It is therefore possible to expect generation of photoelectromotive force in a band of wavelengths from 700 nm to about 820 nm.

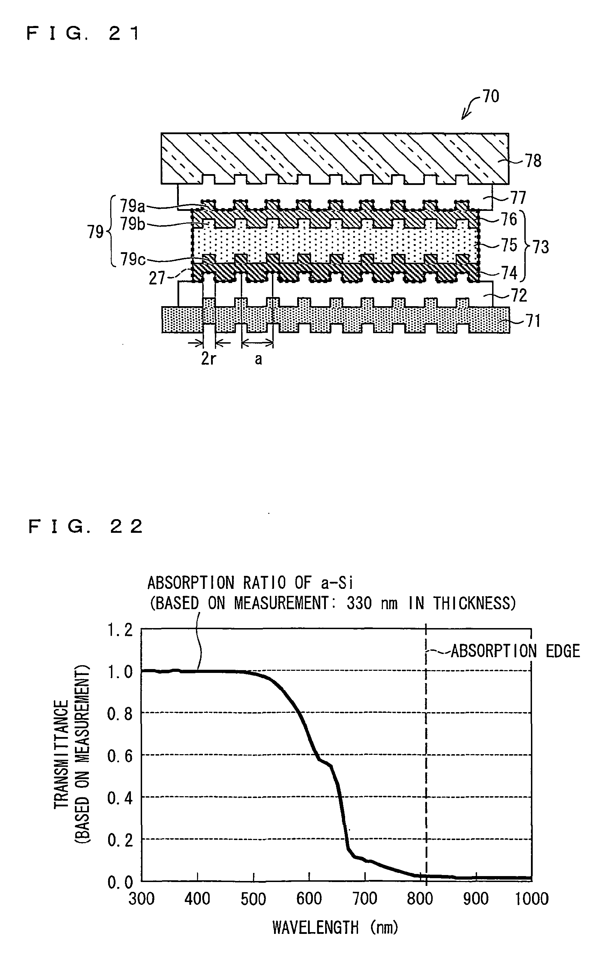

Fig. 22 is a view showing measured ratio of absorption of light by a-Si (thickness: 330 nm) relative to wavelength of the light.

As shown in Fig. 22, in the case of a-Si, the absorption is maintained at its peak while the wavelength is not more than about 520 nm, and the absorptance decreases as the wavelength increases from around 520 nm to 820 nm, which is a wavelength at an absorption edge. This is because an interaction between light and an electron becomes weak between the absorption edge and the absorption peak of the semiconductor and the weakened interaction allows an electromagnetic wave (light) between the absorption edge and the absorption peak to easily transmit through a-Si. Accordingly, an efficiency of photoelectric conversion is decreased between the absorption edge and the absorption peak of the semiconductor. As such, in order for the semiconductor to absorb light sufficiently between the absorption edge and absorption peak, it is necessary to increase the thickness of the semiconductor.

In recent years, for the purpose of improving a light absorption ratio, a photoelectric transducer employing a photonic crystal has been developed as disclosed, for example, in Patent Literature 1 through 4.

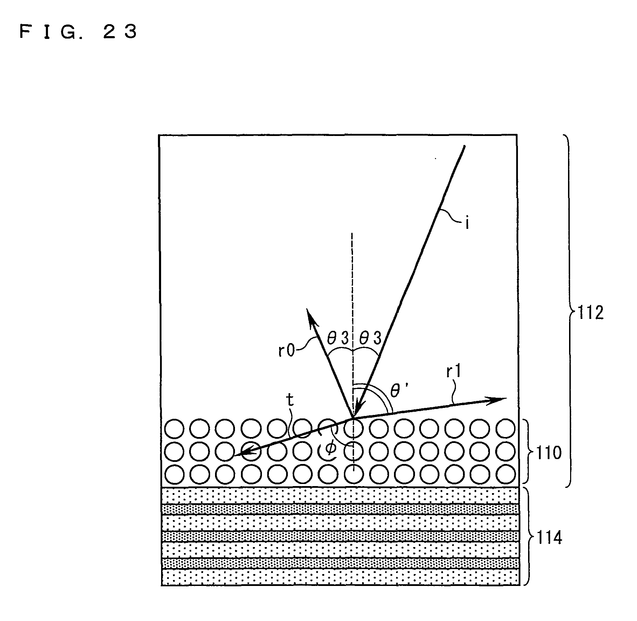

Fig. 23 is a schematic view of a configuration of a solar cell disclosed in Patent Literature 1.

A photonic crystal is produced by artificially forming, within a dialectic, a periodic structure having different permittivities.

As illustrated in Fig. 23, a solar cell 101 includes a distributed Bragg reflector (DBR) 114 and a photovoltaic material 112 laminated on the distributed Bragg reflector 114. A photonic crystalline structure 110, in which a plurality of air holes are formed, is formed in the photovoltaic material 112.

Reflected light r0 is obtained when incident light i, which has entered the photovoltaic material 112, is regularly reflected from the photonic crystalline structure 110. Diffracted light r1 is obtained when the incident light i is diffracted by the photonic crystalline structure 110. Refracted light t is obtained when the incident light i is refracted by the photonic crystalline structure 110.

The diffracted light r1 is diffracted at an angle θ' larger than an incidence angle θ3, and therefore contributes to lengthening a light path inside the photovoltaic material 112. At the interface between the photovoltaic material 112 and the air in the outside, total internal reflection occurs, so that the diffracted light r1 is resonated in the photovoltaic material 112. This improves the light absorption ratio of the photovoltaic material 112.

In addition, the refracted light t and light which is reflected from the distributed Bragg reflector 114 to return to the photonic crystalline structure 110 each cause a resonance by bouncing back and forth inside the photonic crystalline structure 110 and are gradually absorbed. This also improves the light absorption ratio.

In the solar cell 101 as described above, the incident light is resonated in the photovoltaic material 112 and in the photonic crystalline structure 110 so that the light is absorbed. This allows an improvement in absorption efficiency of a photoelectromotive cell. Particularly, by providing a resonance wavelength at a long wavelength side, where the absorption ratio of incident light is low, it becomes possible to provide an absorber capable of absorbing a wide range of wavelengths of sunlight.

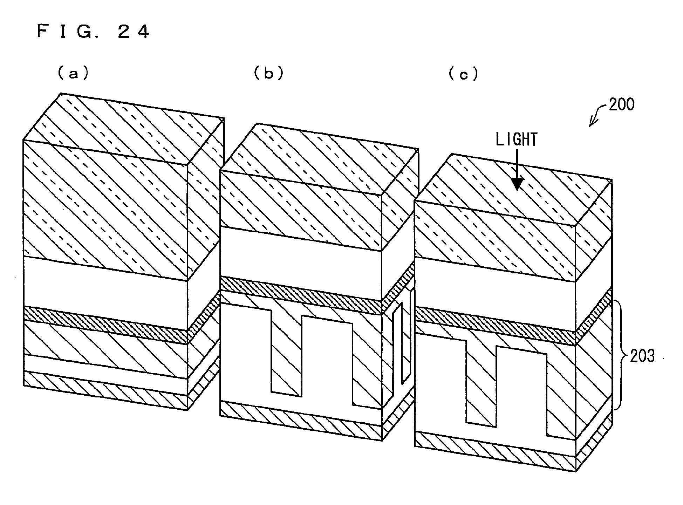

Nonpatent Literature 2 discloses a solar cell employing a photonic crystal in which a band end is provided. A configuration of the solar cell disclosed in Nonpatent Literature 2 will be described below with reference to Fig. 24.

In the solar cell 200 illustrated in Fig. 24, a photovoltaic layer 203 made from an inorganic material is processed so as to form a photonic crystal in the photovoltaic layer 203. By using a band end of the photonic crystal, absorption by the photovoltaic layer 203 is improved. As a result, the use of a band end of a band designed with the photonic crystal allows an improvement in absorption of a wavelength that is absorbed less among wavelengths absorbed in the photovoltaic layer 203. This causes an increase in overall photovoltaic energy.

Citation List

[Patent Literature]

Patent Literature 1
Japanese Translation of PCT International Publication, Tokuhyo, No. 2009-533875 A (Publication Date: September 17, 2009)
Patent Literature 2
Japanese Patent Application Publication, Tokukai, No. 2006-24495 A (Publication Date: January 26, 2006)
Patent Literature 3
Japanese Patent Application Publication, Tokukai, No. 2006-32787 A (Publication Date: February 2, 2006)
Patent Literature 4
International Publication No. W02007/ 108212 [Publication Date: September 27, 2007]

[Nonpatent Literature]

Nonpatent Literature 1
C.Manolatou, M.J.Khan, ShanhuiFan, Pierre R.Villeneuve, H.A.Haus, Life Fellow, IEEE, and J.D.Joannopoulos "Coupling of Modes Analysis of Resonant Channel Add-Drop Filters"/IEEE JOUNAL OF QUANTUM ELECTRONICS/ SEPTEMBER 1999 VOL.35, NO.9, PP.1322-1331
Nonpatent Literature 2
J.R.Tumbleston, Doo-Hyun Ko, Edward T.Samulski, and Rene Lopez "Absorption and quasiguided mode analysis of organic solar cells with photonic crystal photoactive layers"/OPTICS EXPRESS/Optical Society of America/ April 27, 2009 Vol.17, No.9 PP.7670-7681

Summary of Invention

Technical Problem

However, the solar cell 101 disclosed in Patent Literature 1 has the following problem. Since Patent Literature 1 does not have a detailed description of effects brought about by the photonic crystal, it is unclear whether a Q value indicating an effect of resonance (or coefficients $\kappa$ and $\alpha$ (described later) each indicating how easy a coupling is, etc.) is increased or decreased, as an effect of the photonic crystal, in a case where a condition such as thickness is changed photonic crystal.

That is, (1) since the photonic crystal has an effect that (a) an increase in Q value prevents an interaction between light and a device which the light enters, and (b) accordingly, the light is absorbed by the device less easily, a limitless increase in the Q value is not necessarily desirable in order for the photonic crystal to contribute to light absorption.

The inventors of the present invention reviewed the photonic crystal mode coupling theory described in Nonpatent Literature 1. As a result, the inventors newly found that (2) a maximum absorption effect is achieved in a case where ease $\kappa v$ (Qv as a resonator) in coupling between a photonic crystal and an outside world of the photonic crystal, which ease is brought about by a structure of a photonic crystal, is substantially equal to ease $\alpha a$ (Q$\alpha$ as a resonator) in absorption, which ease is an inherent characteristic of photovoltaic device.

As such, in view of the findings (1) and (2), it is problematic that Patent Literature 1 does not explicitly describe, as a design condition of a photonic crystal, any condition for more efficient absorption. In short, it is impossible to gain, from the disclosure of Patent Literature 1, knowledge for sufficiently exhibiting an effect of improvement in absorption by a photonic crystal.

Similarly, Nonpatent Literature 2 does not explicitly describe a condition for more efficient absorption. As such, although it is possible to form a band end by use of a photonic crystal, a wavelength band designed for the photonic crystal to contribute to absorption is narrow. Since the wavelength band at which light is absorbed is thus narrow, improvement in the amount of overall photovoltaic energy relative to a wavelength direction (wavelength band) of the photovoltaic layer 203. Therefore, the solar cell 200 of Nonpatent Literature 2 is problematic in terms of practical use as a device for conducting photoelectric conversion.

The present invention is accomplished in view of the aforementioned problem. An object of the present invention is to increase the light absorption ratio of a photoelectric transducer having a photonic crystalline structure.

Solution to Problem

In order to attain the object, a photoelectric transducer of the present invention is a photoelectric transducer including: a photoelectric conversion layer; and a photonic crystal formed inside the photoelectric conversion layer, (i) the photonic crystal being formed by providing a plurality of columnar media inside the photoelectric conversion layer, each of the plurality of columnar media having a refractive index lower than that of a medium of the photoelectric conversion layer, the plurality of columnar media being provided two-dimensionally and periodically at a pitch of not less than $\lambda/4$ nor more than $\lambda$, where $\lambda$ is a wavelength of a peak of resonance caused by the photonic crystal, (ii) the photoelectric transducer satisfying the following formula:

$$0.2Q_v \leq Q_a \leq 5.4Q_v$$

where Qv is (a) a Q value which indicates a magnitude of an effect of resonance caused by coupling between the photonic crystal and an external world and (b) in proportion to a reciprocal of a coefficient $\kappa_v$ indicating a strength of the coupling between the photonic crystal and the external world, and Qa is (a) a Q value which indicates a magnitude of an effect of resonance caused by the medium of the photoelectric conversion layer and (b) in proportion to a reciprocal of a coefficient of light absorption by the medium of the photoelectric conversion layer.

According to the configuration, the photonic crystal is formed inside the photoelectric conversion layer. This allows light which has entered the photoelectric conversion layer to resonate by means of the photonic crystal.

In addition, in the photonic crystal, the plurality of columnar media are two-dimensionally arranged at a itch of not less than $\lambda/4$ nor more than $\lambda$. This causes a band end to be formed at a point r in a reciprocal space of the photonic crystal, and a wavelength of light defined by the band end becomes $\lambda$.

This makes it possible to (a) confine, within the photoelectric conversion layer in which the photonic crystal is provided, incident light entering the photoelectric conversion layer in a direction perpendicular to the photoelectric conversion layer and having the wavelength $\lambda$ out of light entering the photoelectric conversion layer and (b) cause the confined light to be resonated. The light having the resonance peak wavelength $\lambda$ and having been resonated with angle dependency in the photoelectric conversion layer is absorbed by the medium of the photoelectric conversion layer.

Here, in a case where the coefficient $\kappa_v$ is substantially equal to the coefficient of absorption, in other words, in a case where $Q_v$ and $Q_\alpha$ are substantially equal to each other, light absorption by the medium of the photoelectric conversion layer is at maximum, and the wavelength band of the absorbed light is at maximum.

Note that, even if $Q_v$ and $Q_\alpha$ are not substantially equal to each other, in a case as above where the condition $0.2Qv \leq Q_\alpha \leq 5.4Qv$ is met, the effect of light absorption by the photonic crystal is enhanced.

Therefore, the configuration allows increasing the light absorption ratio of the photoelectric transducer having a photonic crystalline structure, and consequently allows increasing photoelectromotive force at the aforementioned band approximately between 520 nm to 820 nm in wavelength. Furthermore, by matching the wavelength of a resonance peak defined by the band end with a wavelength band at which the ratio of absorption by the medium of photoelectric conversion layer is low, the photoelectric transducer can absorb light in a wider wavelength band.

A photoelectric transducer of the present invention is a photoelectric transducer including: a photoelectric conversion layer including a plurality of semiconductors being laminated; and a photonic crystal formed inside the photoelectric conversion layer, at least one of the plurality of semiconductors having a plurality of protrusions, the photonic crystal including the at least one of the plurality of semiconductors which has the plurality of protrusions, the plurality of protrusions being provided two-dimensionally and periodically at a pitch of not less than $\lambda/4$ nor more than $\lambda$, where $\lambda$ is a wavelength of a peak of resonance caused by the photonic crystal, the photoelectric transducer satisfying the following formula:

$$0.2Q_v \leq Q_a \leq 5.4Q_v$$

where Qv is (a) a Q value which indicates a magnitude of an effect of resonance caused by coupling between the photonic crystal and an external world and (b) in proportion to a reciprocal of a coefficient $\kappa_v$ indicating a strength of the coupling between the photonic crystal and the external world, and Qa is (a) a Q value which indicates a magnitude of an effect of resonance caused by the medium of the photoelectric conversion layer and (b) in proportion to a reciprocal of a coefficient of light absorption by the medium of the photoelectric conversion layer.

As in this configuration, a photonic crystal can be constituted by forming a plurality of protrusions in a semiconductor layer. In the photonic crystal thus formed, the plurality of protrusions are arranged two-dimensionally and periodically at a pitch of not less than $\lambda/4$ nor more than $\lambda$, so that a band end is formed in a point $\Gamma$ direction. This makes it possible to (a) confine, within the photoelectric conversion layer, incident light entering the photoelectric conversion layer in a direction perpendicular to the photoelectric conversion layer and having the wavelength $\lambda$ out of light entering the photoelectric conversion layer and (b) cause the confined light to be resonated. The light having the resonance peak wavelength $\lambda$ and having been resonated in the photoelectric conversion layer is absorbed by the medium of the photoelectric conversion layer.

In a case where the coefficient $\kappa_v$ and the coefficient of absorption are substantially equal to each other, in other words, in a case where $Q_v$ and $Q_\alpha$ are substantially equal to each other, the absorption of light by the medium of the photoelectric conversion layer is at maximum, and the wavelength band of the absorbed light is at maximum.

Note that, even if $Q_v$ and $Q_\alpha$ are not substantially equal to each other, in a case where the condition $0.2Q_v \leq Q_\alpha \leq 5.4Qv$ is met as described above, the effect of absorption of light by the photonic crystal is enhanced.

Therefore, the configuration allows increasing the light absorption ratio of the photoelectric transducer having a photonic crystalline structure, and consequently allows increasing photoelectromotive force at the aforementioned band approximately between 520 nm to 820 nm in wavelength. Furthermore, by matching the wavelength of a resonance peak defined by the band end with a wavelength band at which the ratio of absorption by the medium of photoelectric conversion layer is low, the photoelectric transducer can absorb light in a wider wavelength band.

Advantageous Effects of Invention

A photoelectric transducer of the present invention is a photoelectric transducer including: a photoelectric conversion layer; and a photonic crystal formed inside the photoelectric conversion layer, the photonic crystal being formed by providing a plurality of columnar media inside the photoelectric conversion layer, each of the plurality of columnar media having a refractive index lower than that of a medium of the photoelectric conversion layer, the plurality of columnar media being provided two-dimensionally and periodically at a pitch of not less than $\lambda/4$ nor more than $\lambda$, where $\lambda$ is a wavelength of a peak of resonance caused by the photonic crystal, the photoelectric transducer satisfying the following formula:

$$0.2Qv \leq Q_\alpha \leq 5.4Qv$$

where Qv is (a) a Q value which indicates a magnitude of an effect of resonance caused by coupling between the photonic crystal and an external world and (b) in proportion to a reciprocal of a coefficient $\kappa_v$ indicating a strength of the coupling between the photonic crystal and the external world, and Qa is (a) a Q value which indicates a magnitude of an effect of resonance caused by the medium of the photoelectric conversion layer and (b) in proportion to a reciprocal of a coefficient of light absorption by the medium of the photoelectric conversion layer.

A photoelectric transducer of the present invention is a photoelectric transducer including: a photoelectric conversion layer including a plurality of semiconductors being laminated; and a photonic crystal formed inside the photoelectric conversion layer, at least one of the plurality of semiconductors having a plurality of protrusions, the photonic crystal including the at least one of the plurality of semiconductors which has the plurality of protrusions, the plurality of protrusions being provided two-dimensionally and periodically at a pitch of not less than $\lambda/4$ nor more than $\lambda$, where $\lambda$ is a wavelength of a peak of resonance caused by the photonic crystal, the photoelectric transducer satisfying the following formula:

$$0.2Qv \leq Q_\alpha \leq 5.4Qv$$

where Qv is (a) a Q value which indicates a magnitude of an effect of resonance caused by coupling between the photonic crystal and an external world and (b) in proportion to a reciprocal of a coefficient $\kappa_v$ indicating a strength of the coupling between the photonic crystal and the external world, and Qa is (a) a Q value which indicates a magnitude of an effect of resonance caused by the medium of the photoelectric conversion layer and (b) in proportion to a reciprocal of a coefficient of light absorption by the medium of the photoelectric conversion layer.

Therefore, it is possible to improve the light absorption ratio of a photoelectric transducer.

Brief Description of Drawings

Fig. 1

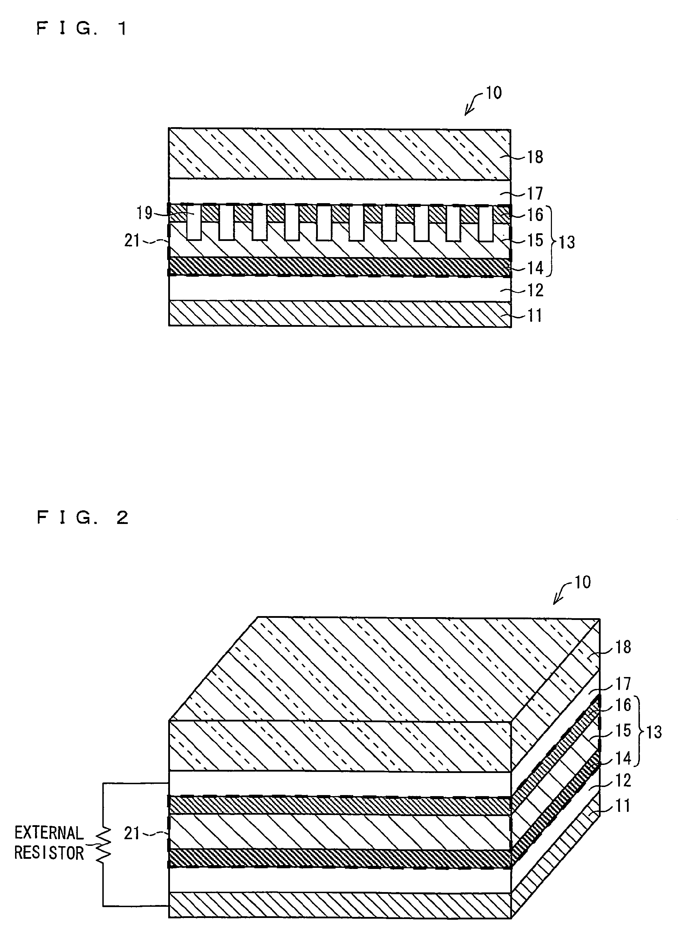

Fig. 1 is a cross-sectional view illustrating a configuration of a photoelectric transducer of the present invention.
Fig. 2
Fig. 2 is a perspective view illustrating a configuration of a photoelectric transducer of the present invention.
Fig. 3

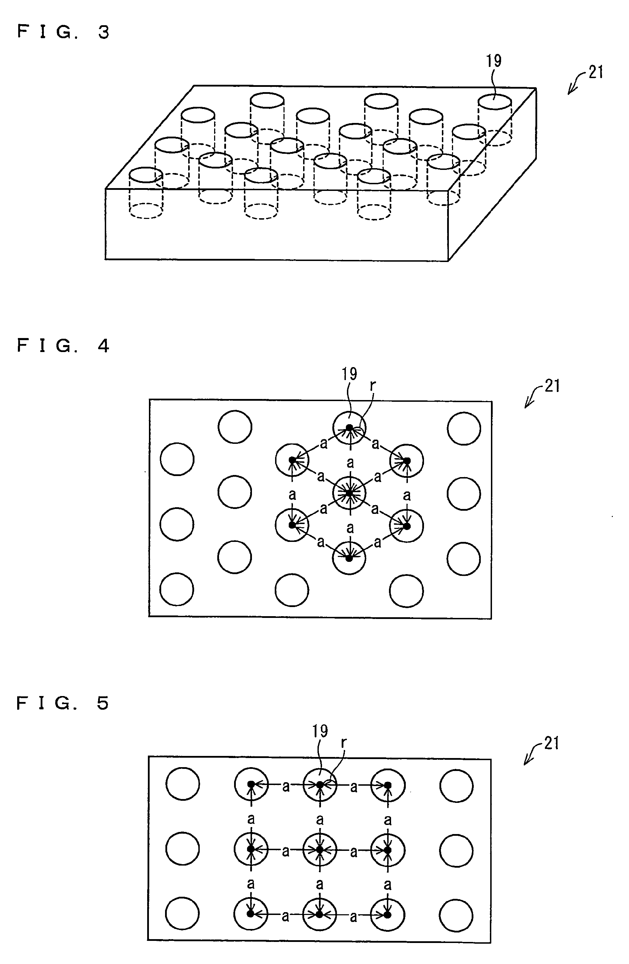

Fig. 3 is a perspective view illustrating a configuration of a photonic crystal of a photoelectric transducer of the present invention.
Fig. 4
Fig. 4 is a plan view illustrating a configuration of a photonic crystal of the photoelectric transducer of the present invention, which photonic crystal has a triangular lattice structure.
Fig. 5
Fig. 5 is a plan view illustrating a configuration of a photonic crystal of the photoelectric transducer of the present invention, which photonic crystal has a square lattice structure.
Fig. 6

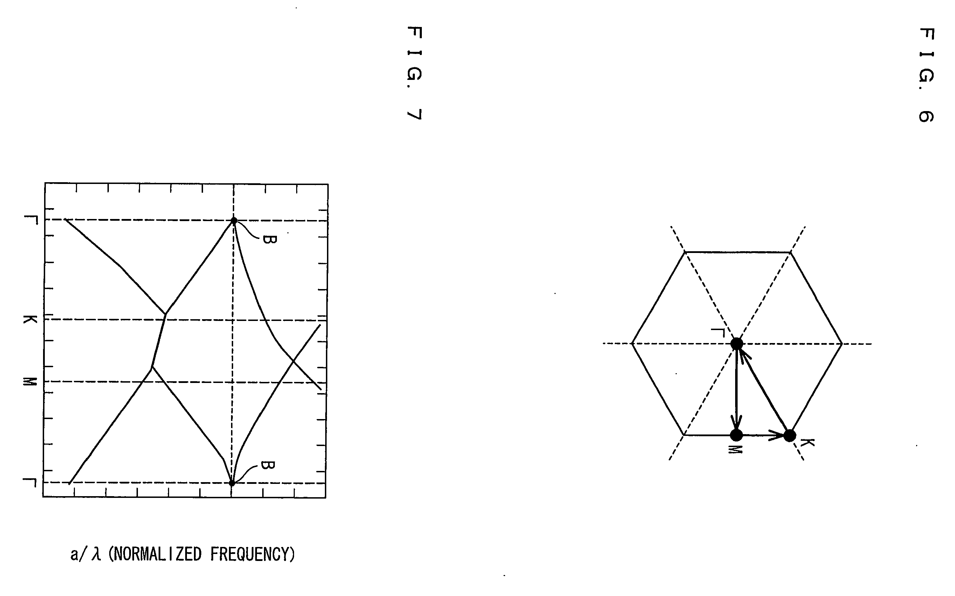

Fig. 6 is an explanatory view showing positions in a reciprocal space of a triangular lattice structure (a plane cross section structure in a hexagonal close-packed structure).
Fig. 7
Fig. 7 is a view showing a photonic band in a photonic crystal.
Fig. 8

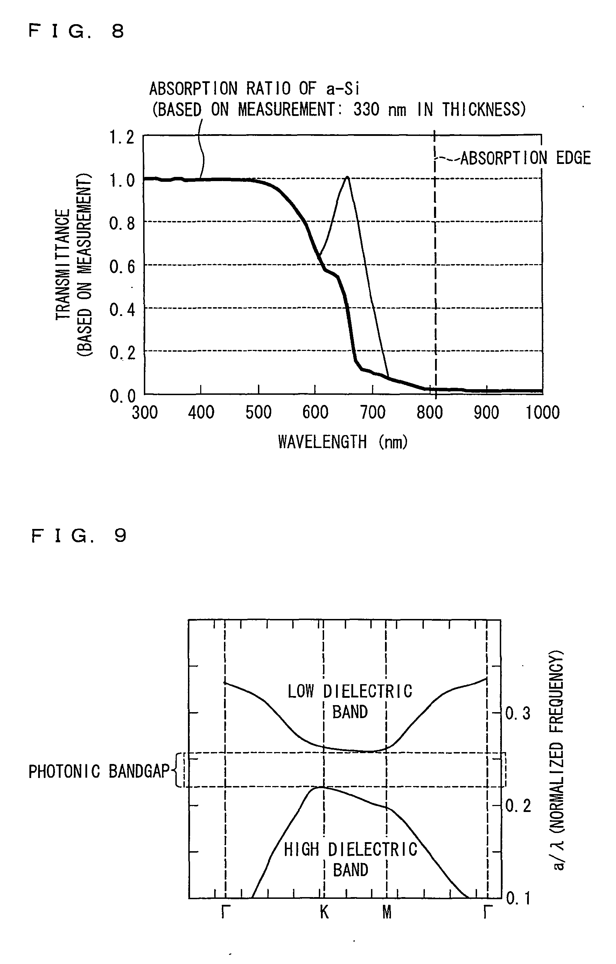

Fig. 8 is a view showing absorption wavelengths in a photoelectric transducer of the present invention.
Fig. 9
Fig. 9 is a view showing a photonic band in which a band gap is formed.
Fig. 10

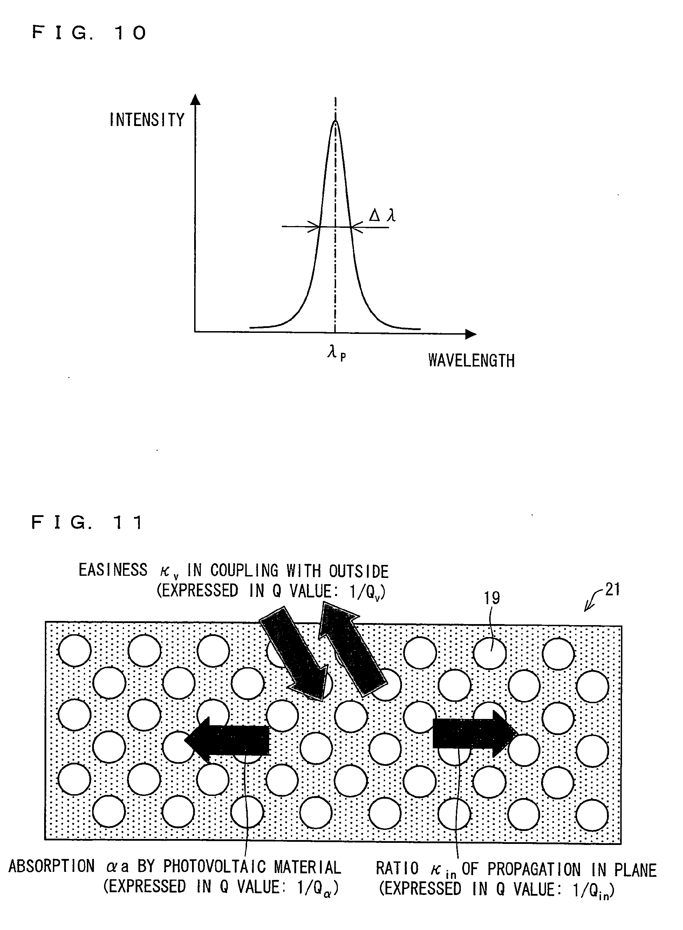

Fig. 10 is a graph showing a light resonance peak in relation to wavelength and strength.
Fig. 11
Fig. 11 is an explanatory view illustrating a relation between (i) a magnitude of coupling in a photovoltaic device having a photonic crystal and (ii) a Q value.
Fig. 12

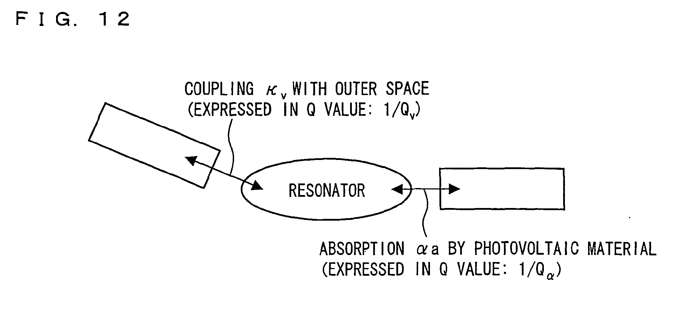

Fig. 12 is an explanatory view for explaining a Q value of a resonator made of a defect in a photonic crystal.
Fig. 13

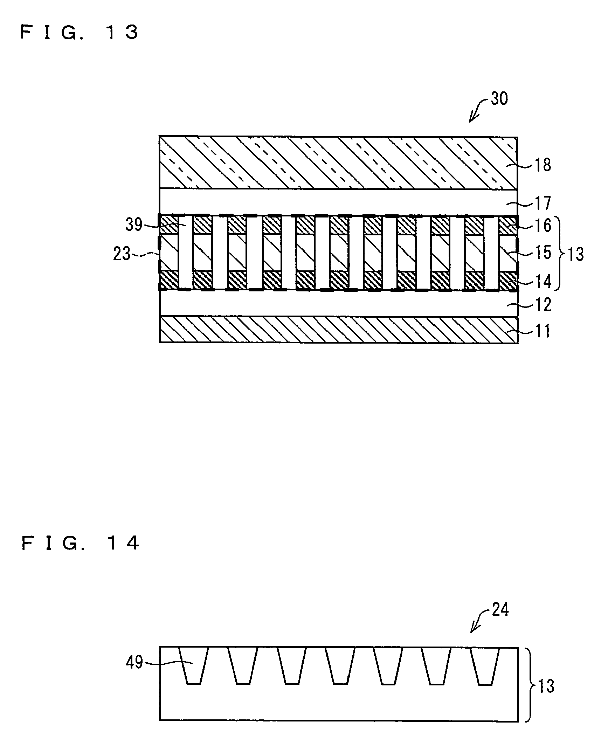

Fig. 13 is a cross-sectional view illustrating a configuration of a photoelectric transducer of the present invention.
Fig. 14
Fig. 14 is a cross-sectional view illustrating a configuration of a photonic crystal in which nanorods each having a trapezoidal cross section are formed.
Fig. 15

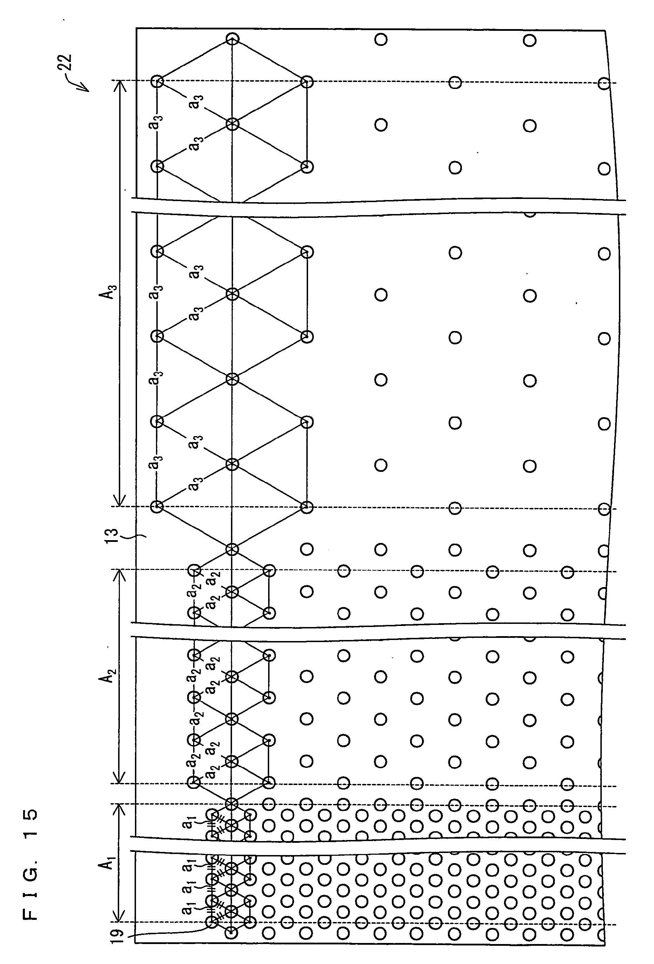

Fig. 15 is a plan view illustrating a configuration of a photonic crystal in which a pitch between nanorods differs among regions.
Fig. 16

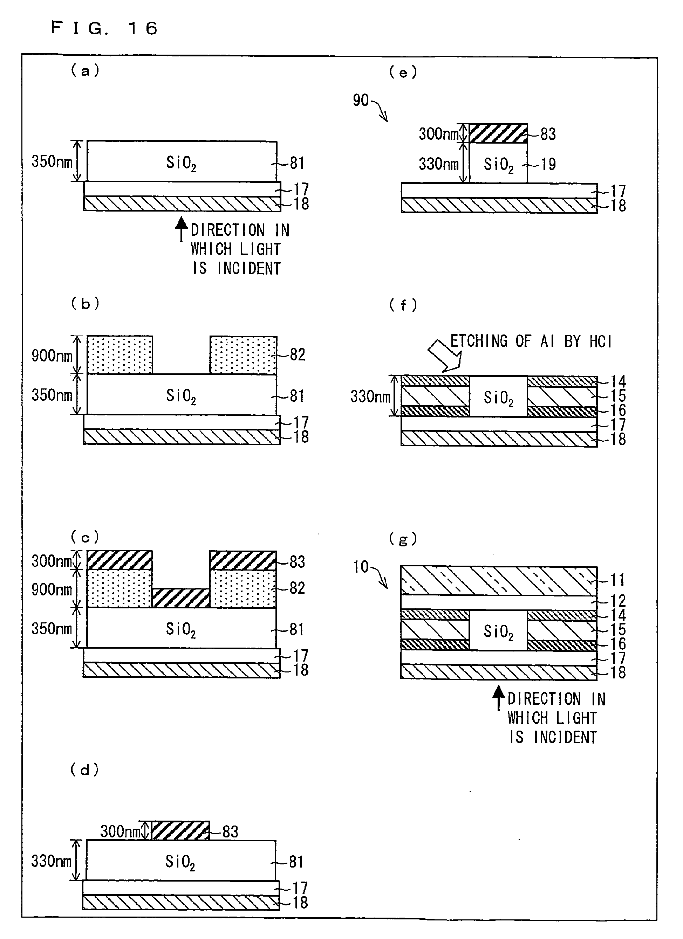

Fig. 16 is a process drawing illustrating a process for manufacturing a photoelectric transducer.
Fig. 17

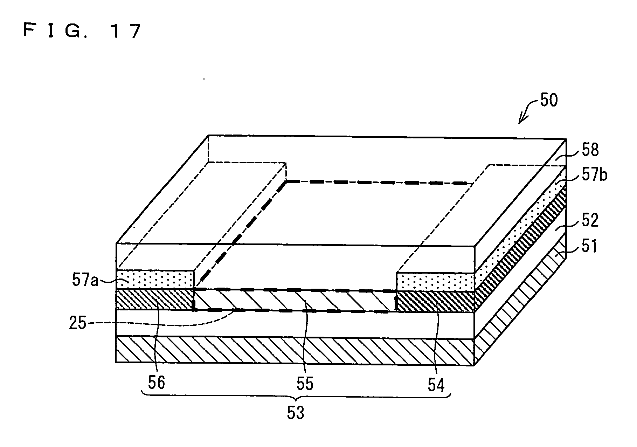

Fig. 17 is a perspective view illustrating a configuration of a photoelectric transducer in accordance with a Second Embodiment.
Fig. 18

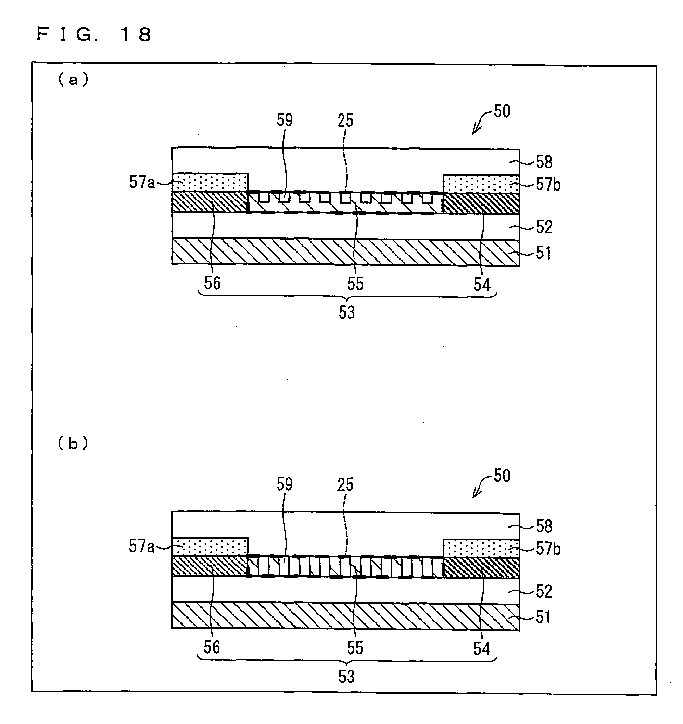

(a) of Fig. 18 is a cross-sectional view illustrating a configuration of a photoelectric transducer in accordance with the Second Embodiment. (b) of Fig. 18 is a cross-sectional view illustrating another example of configuration of a photoelectric transducer in accordance with the Second Embodiment.

Fig. 19

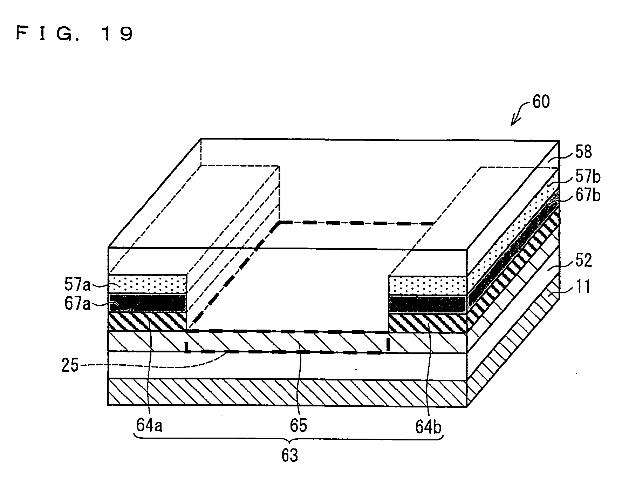

Fig. 19 is a perspective view illustrating a configuration of a photoelectric transducer in accordance with a Third Embodiment.
Fig. 20

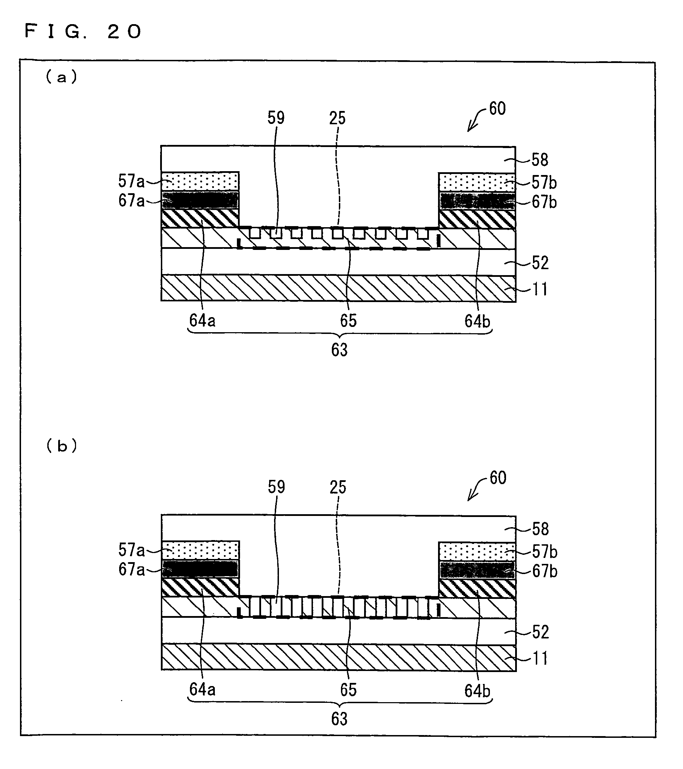

(a) of Fig. 20 is a cross-sectional view illustrating a configuration of a photoelectric transducer in accordance with the Third Embodiment. (b) of Fig. 20 is a cross-sectional view illustrating another example of configuration of a photoelectric transducer in accordance with the Third Embodiment.

Fig. 21
Fig. 21 is a perspective view illustrating a configuration of a photoelectric transducer in accordance with a Fourth Embodiment.
Fig. 22
Fig. 22 is a graph showing relations between light absorption ratio of a-Si and wavelength of light.
Fig. 23
Fig. 23 is a schematic view illustrating a configuration of a conventional solar cell including a photonic crystal.
Fig. 24
Fig. 24 is a perspective view illustrating a configuration of a solar cell employing a conventional photonic crystal.

Description of Embodiments

The following description will discuss in detail embodiments of the present invention.

[Embodiment 1]

(Configuration of photoelectric transducer)

Fig. 1 is a cross-sectional view illustrating a configuration of a photoelectric transducer 10 of the present invention. Fig. 2 is a perspective view illustrating a configuration of the photoelectric transducer 10.
The photoelectric transducer 10 is an element which converts incident light into an electric current by means of photoelectric conversion. The photoelectric transducer 10 can be used in a device for converting light into an electric signal, such as a solar cell and an optical sensor.
The photoelectric transducer 10 includes a semiconductor layer (photoelectric conversion layer) 13 for subjecting incident light to photoelectric conversion. Inside the semiconductor layer 13, a photonic crystal 21 is formed. The photonic crystal 21 is realized by formation of a plurality of nanorods (columnar media) 19 each having a refractive index different from that of the semiconductor layer 13.
The light absorption ratio of the photoelectric transducer 10 is improved by causing a wavelength of light, which is in a state corresponding to a band end formed by the photonic crystal 21, to resonate strongly. A configuration of the semiconductor layer 13, in which the photonic crystal 21 is provided, will be described later in detail.
The photoelectric transducer 10 includes a rear surface metal electrode 11 (metal layer) provided in an outermost layer of the photoelectric transducer 10 on a side opposite to a side from which light enters the photoelectric transducer 10, a transparent conductive film 12 laminated on the rear surface metal electrode 11, the semiconductor layer 13 laminated on the transparent conductive film 12, a transparent conductive film 17 laminated on the semiconductor layer 13, and a glass 18 laminated on the transparent conductive film 17. The transparent conductive film 17 is one of two layers each made from a medium having a refractive index lower than that of a medium of the semiconductor layer 13. The transparent conductive film 12 is the other of the two layers.
In the photoelectric transducer 10, a surface of the glass 18 which is opposite to a surface of the glass 18 which is in contact with the transparent conductive film 17 is a light incidence surface, through which light enters. The photoelectric transducer 10 subjects incident light, which has entered the photoelectric transducer 10 through the incidence surface, to photoelectric conversion in the semiconductor layer 13, so that an electric current is generated in accordance with an amount of the incident light. The electric current can be outputted to the outside as an electric signal by, for example, connecting the rear surface metal electrode 11 and the transparent conductive film 17, which are arranged so as to sandwich the semiconductor layer 13 therebetween, with each other via an external resistor.
In the following description, a light incidence surface (side) of the photoelectric transducer 10 will be referred to as a front surface (side) of the photoelectric transducer 10, and a surface (side) of the rear surface metal electrode 11 which is opposite to another surface of the rear surface electrode 11 which is in contact with the semiconductor layer 13 will be referred to as a rear surface (side) of the photoelectric transducer 10. Likewise, a surface (side) of each of the films constituting the photoelectric transducer 10, which surface (side) is arranged on the incidence surface side, will be referred to as a front surface (side) of the each of the films, and another surface (side) of the each of the films, which surface (side) is arranged on the rear surface metal electrode 11 side, will be referred to as a rear surface (side) of the each of the films.
The glass 18 is made from, for example, a material having a refractive index of about 1.52.
The rear surface metal electrode 11 is made from a metal having a high reflectivity, such as Ag and A1. The rear surface metal electrode 11 is provided for extracting an electric current generated through photoelectric conversion in the semiconductor layer 13 and outputting the electric current to the outside.

The rear surface metal electrode 11 can also function as a reflecting plate. Light which has been transmitted through the semiconductor layer 13 instead of being subjected to photoelectric conversion in the semiconductor layer 13 can be reflected by the rear surface metal electrode 11 so as to travel back to the semiconductor layer 13. By providing the rear surface metal electrode 11 so as to cover the entire rear surface of the semiconductor layer 13, the photoelectric transducer 10 can be configured to absorb light more efficiently, since the photoelectric transducer 10 can reliably reflect the light that has been transmitted through the semiconductor layer 13.

The transparent conductive films (TCO; Transparent Conducing Oxide) 12 and 17 are transparent conductive films and are arranged so as to sandwich the semiconductor layer 13 therebetween. Each of the transparent conductive films 12 and 17 is made from a medium, such as ITO, ZnO, and $SnO_2$, which has a refractive index lower than that of the medium of the semiconductor layer 13.

The semiconductor layer 13 is a photovoltaic material and is made from, for example, a-Si (amorphous silicon). The semiconductor layer 13 is an electromagnetic layer for generating an electric current by subjecting incident light to photoelectric conversion. In the present embodiment, the semiconductor layer 13 is a p-i-n type semiconductor constituted by an n-type semiconductor (n-type semiconductor layer) 14, an i-type semiconductor (intrinsic semiconductor layer) 15, and a p-type semiconductor (p-type semiconductor layer) 16, which are laminated in this order from the rear surface side (the side where the transparent conductive film 17 is provided).

In the semiconductor layer 13, the photonic crystal 21 is provided. The photonic crystal 21 is a two-dimensional photonic crystal having a periodic structure in which the plurality of nanorods 19, each having a refractive index lower than refractive indices of the n-type semiconductor 14, the i-type semiconductor 15, and the p-type semiconductor 16, are arranged two dimensionally and regularly.

(Configuration of photonic crystal)

Next, a configuration of the photonic crystal 21 will be described.

As illustrated in Fig. 1, the photonic crystal 21 is provided in the semiconductor layer 13 and is a two-dimensional photonic crystal in which the plurality of nanorods 19 are periodically arranged within the medium of the semiconductor layer 13 having a thickness of about a wavelength of light.

In the semiconductor layer 13, a region where the plurality of nanorods 19 are provided is the photonic crystal 21. In the present embodiment, the plurality of nanorods 19 are formed over the entire front surface of the semiconductor layer 13.

Each of the plurality of nanorods 19 is made from a material having a refractive index lower than that of a-Si which constitutes the n-type semiconductor 14, the i-type semiconductor 15, and the p-type semiconductor 16. That is, the plurality of nanorods 19 serve as low-refractive index regions in the semiconductor layer 13. Each of the plurality of nanorods 19 has an insulating function, is made from a material having high transmittance, and serves as a low-refractive index region in the semiconductor layer 13. Each of the plurality of nanorods 19 is made from a material having a refractive index of about 1.0 to 2.0. Examples of the material encompass the air, and $SiO_2$ having a refractive index of 1.45.

The examples of the material of the each of the plurality of nanorods 19 also encompass HSQ (Hydrogen Silsequioxane), which can be used as a JAS (transparent resin material) and an SOG (Spin-on Glass) material, each of which has a refractive index of about 1.6. The HSQ can be, for example, FOX® (registered trade name of Dow Corning Toray Co., Ltd).

Each of the plurality of nanorods 19 is formed so as to have a height (length along a thickness direction of the semiconductor layer 13) which is not more than 1/4 of a thickness of the semiconductor layer 13 or equal to the thickness of the semiconductor layer 13.

As illustrated in Fig. 3, each of the plurality of nanorods 19 is formed in the semiconductor layer 13 so as to have a columnar shape such as a cylindrical shape. Fig. 3 is a perspective view illustrating a configuration of the photonic crystal 21.

Fig. 4 is a plan view illustrating a configuration of the photonic crystal 21 in which the plurality of nanorods 19 are arranged in a triangular lattice. As illustrated in Fig. 4, the photonic crystal 21 is constituted by the plurality of nanorods 19 arranged two-dimensionally and periodically so that a band end is formed at a point r in a reciprocal space (to be described later).

Specifically, the plurality of nanorods 19 are arranged periodically so that a pitch (interval) a between the plurality of nanorods 19 is not less than $\lambda/4$ nor more than $\lambda$ (where $\lambda$ is a wavelength). Note that the wavelength $\lambda$ is a wavelength defined by a band end, as described later. That is, the wavelength $\lambda$ is a resonance peak wavelength of wavelengths to be caused to resonate by means of the photonic crystal 21.

In a plan view of the photonic crystal 21, the plurality of nanorods 19 are arranged on respective apices of triangles, so that the plurality of nanorods 19 are arranged periodically on respective apices of and a center of a hexagon. That is, the photonic crystal 21 has a structure in which the plurality of nanorods 19 are arranged two-dimensionally in a triangular lattice.

Alternatively, as illustrated in Fig. 5, the plurality of nanorods 19 can be arranged on respective apices of squares, in a plan view of the photonic crystal 21. That is, the photonic crystal 21 can have a structure in which the plurality of nanorods 19 are two-dimensionally arranged in a square lattice.

Fig. 5 is a plan view illustrating a configuration of the photonic crystal 21 in which the plurality of nanorods 19 are arranged in a square lattice.

In either type of lattice, a band end can be formed at a point r in a reciprocal space (to be described later).

Each of the plurality of nanorods 19 preferably has a radius in a range of 0.2a to 0.4a, with reference to the pitch a.

Next, the following description will discuss a band end which is formed in the photoelectric transducer 10 in which the plurality of nanorods 19 are arranged in the semiconductor layer 13 as described above.

(Band end)

Fig. 6 is a view illustrating positions in a reciprocal space of a triangular lattice (a plane cross section structure in a hexagonal close-packed structure). Fig. 7 is a view illustrating photonic bands in the photonic crystal 21.

An orientation in an in-plane direction in the photonic crystal 21 can be indicated using a crystal orientation indicated by a reciprocal space vector of a triangular lattice (a two-dimensional plane section of a hexagonal close-packed structure in crystal engineering), as illustrated in Fig. 6. This is because a crystal arrangement experienced by light that has entered the photonic crystal 21, which is the semiconductor layer 13, corresponds to an arrangement represented in a reciprocal space (a first Brillouin zone).

In Fig. 6, the point K indicates one of the corners of a regular hexagonal lattice shape surrounding the point r. The point M is a point between the corner and another corner adjacent thereto. The triangle defined by the point r, the point K, and the point M is a unit lattice. A reciprocal space represented by the hexagon includes 12 unit lattices. By determining directions with respect to one unit lattice, it is possible to determine directions with respect to all of the unit lattices.

The direction indicated by the point r in Fig. 6 corresponds to a direction from directly above the photonic crystal 21 to the surface of the photonic crystal 21 (i.e., direction in which light enters the semiconductor layer 13 in a vertical direction.

Each of the reciprocal space vectors respectively indicated by the arrow $\Gamma$M, the arrow MK, and the arrow K$\Gamma$ in Fig. 6 represents a direction within a plane of the photonic crystal 21. A direction within the plane of the photonic crystal 21 is expressed by use of a combination of a starting point and an end point, such as $\Gamma$M, MK, or K$\Gamma$. For example, light having a specific wavelength is propagated in a direction from the point $\Gamma$ to the point K.

In Fig. 7, the vertical axis shows normalized frequency and the horizontal axis shows position in the reciprocal space.

The normalized frequency is a parameter used because the pitch a of the photonic crystal 21 and the frequency of light correlate with each other, and is represented by $a/\lambda$. Therefore in Fig. 7, the wavelength $\lambda$ decreases along the vertical axis toward the top of the graph.

Bands shown in Fig. 7 are obtained by connecting points of wavelengths that resonate in the photonic crystal 21.

As described above, the photonic crystal 21 has a configuration in which the plurality of nanorods 19 are periodically arranged so that the pitch a is not less than 1/4 of the wavelength $\lambda$ nor more than the wavelength $\lambda$. As such, as shown in Fig. 7, a band end B, which is an extreme value of the photonic bands of the photonic crystal 21, is formed at the point r.

At the band end B, the wavelength $\lambda$ at a resonance peak corresponding to the normalized frequency strongly resonates in the entire plane of the photonic crystal 21. By achieving an effect of resonance at the band end B, it is possible to increase lifetime of light that has entered the semiconductor layer 13. An interaction between the semiconductor layer 13 and the light during the increased lifetime allows an improvement in the absorption ratio in the semiconductor layer 13.

Thus, the configuration of the photonic crystal 21 allows utilization of the band end B, at which only light having entered the photonic crystal 21 in a direction, called point r, perpendicular to the photonic crystal 21 can be resonated.

By utilizing the band end B, light having entered the photonic crystal 21 in the direction perpendicular to the photonic crystal 21 and having the wavelength $\lambda$, out of light having entered the photonic crystal 21, can be resonated in the photonic crystal 21. The light having the wavelength $\lambda$ and having been resonated in the photonic crystal 21 is absorbed by the medium of the semiconductor layer 13.

Consequently, the light absorption ratio of the photoelectric transducer 10 can be improved.

Fig. 8 shows wavelengths absorbed by the photoelectric transducer 10. As shown in Fig. 8, in the photoelectric transducer 10, it is possible to improve the absorption ratio of a wavelength that resonates at the band end B, in addition to the absorptance of wavelengths absorbed in a normal semiconductor made from a-Si. In the photoelectric transducer 10 of the present embodiment, it is possible to improve the absorption ratio of wavelengths near 650 nm, which are poorly absorbed wavelengths between a wavelength (near 820 nm) at an absorption edge of a-Si to a resonance peak wavelength (520 nm) of a-Si. These wavelengths, the absorbance of which is to be improved, can be changed from corresponding normalized frequencies by changing the pitch a between the plurality of nanorods.

Note that the normalized frequency defined by the band end B is approximately 0.3 to 0.5.

As described above, in the photoelectric transducer 10, it is possible to improve the light absorption ratio in the entire plane of the photonic crystal 21 by causing incident light from a specific angle to resonate strongly in the photonic crystal 21. Particularly, by providing a resonance peak within a range of poorly absorbed wavelengths between an absorption edge of the semiconductor and an absorption peak of the semiconductor, the absorption ratio of the photoelectric transducer 10 as a whole can be improved.

Furthermore, the photoelectric transducer 10 has a configuration in which only light having entered the photoelectric transducer 10 in a direction, called point r, perpendicular to the photoelectric transducer 10, is resonated. Light that can be resonated in the photoelectric transducer 10 is light that has entered the photoelectric transducer 10 at an incidence angle of about 90° ± 1°.

That is, according to the configuration of the photonic crystal 21, incident light having entered the semiconductor layer 13 at an incident angle $\theta 1$ (which substantially satisfies $-1° \leq \theta 1 \leq 1°$) can be caused to resonate at the band end B formed by the point r, where $\theta$ is an incident angle of light entering the semiconductor layer 13 in a direction perpendicular to the semiconductor layer 13. Here, $\theta 1$ is determined in accordance with a length of the band that has the same frequency with respect to in-plane direction components (M direction or K direction) at the band end B.

The light which has the wavelength $\lambda$ at the resonance peak and has been resonated in the semiconductor layer 13 as above is absorbed by the medium of the semiconductor layer 13.

That is, according to the photoelectric transducer 10, it is possible to limit an incident angle of light having a wavelength to be resonated strongly. This allows the photoelectric transducer 10 to be used as, for example, an optical sensor element for an element for sensing an incidence angle of light.

In addition, no band gap is formed in the photonic crystal 21 of the photoelectric transducer 10, since the pitch a between the plurality of nanorods 19 is set to a value not less than 1/4 of the wavelength $\lambda$ nor more than the wavelength $\lambda$.

Fig. 9 is a view showing photonic bands with a band gap formed therebetween. A photonic band is a wavelength band (forbidden band) of light that cannot exist in a photonic crystal.

For example, in a case where the band gap is formed by the photonic crystal between a high dielectric band and a low dielectric band, light having a wavelength within the band gap cannot enter the photonic crystal. Because of this, efficiency of absorption of light within a wavelength band corresponding to normalized frequencies in the band gap.

In contrast, in the photoelectric transducer 10, a resonance condition, which is determined by setting the pitch a between the plurality of nanorods 19 to not less than 1/4 of the wavelength $\lambda$ nor more than the wavelength $\lambda$, is selected. The selection can prevent formation of a band gap in the photonic crystal 21, thereby preventing reflection of a specific wavelength due to the band gap. Consequently, light absorption efficiency can be improved.

Thus, owing to the photonic crystal 21 formed in the semiconductor layer 13, the photoelectric transducer 10 can efficiently take in light which has a specific wavelength and enters the photoelectric transducer 10 from outside at a specific incidence angle. This allows (i) the amount of photovoltaic energy in the optical semiconductor layer to be increased due to an increase in the amount of light absorbed per unit area and (ii) directivity to be improved.

(Design of photonic crystal based on Q value)

The following description will discuss the magnitude of coupling in light between the external world of the photoelectric transducer 10 and the photonic crystal 20, in terms of a Q value. The Q value here indicates the magnitude of a resonance effect of light as electromagnetic waves, similarly with the Q value regarding resonance in electric engineering. The Q value can be represented in various ways, and can be represented by the following Formula 1 or 2.

$$Q = \lambda_p / \Delta\lambda \qquad \ldots \text{Formula 1}$$

$$Q = \omega U / (-dU/dt) \qquad \ldots \text{Formula 2}$$

Fig. 10 is a graph showing a resonance peak of light in relation to wavelength and intensity. As shown in Fig. 10, $\lambda_p$ in Formula 1 indicates a wavelength at a resonance peak, and $\Delta\lambda$ is a half bandwidth.

In Formula 2, $\omega$ indicates a resonant angular frequency, U indicates internal energy in the resonator, and t indicates a time.

According to Formula 1, the smaller the half bandwidth $\Delta\lambda$, the stronger the resonance. Accordingly, the stronger the resonance, the larger the Q value. Further, as the resonance is stronger, the amplitude of the resonance is larger and waves are less apt to attenuate. Accordingly, the larger the Q value, the longer the time (life time) during which light exists in the resonator.

According to Formula 2, the smaller the energy lost from the resonator, i.e., the smaller -dU/dt, the larger the Q value. It follows then that the Q value also indicates the strength with which the resonator confined light.

In a case of forming a photonic crystal in a laser diode or the like, it is desired that resonance be intensified so as to increase light emission intensity. As such, in the designing of the photonic crystal in this case, it is expected that the Q value be set as large as possible.

On the contrary, in the present invention, it is expected that the Q value be set as small as possible so as to (a) broaden the wavelength band of light confined in the resonator (i.e., broaden the half bandwidth) and (b), owing to a consequent facilitation of coupling in light between the external world and the photonic crystal, shorten the lifetime of the light, thereby enabling more amount of light to be absorbed by a semiconductor layer.

In the following description, the photonic crystal 21 in which the plurality of nanorods 19 illustrated in Fig. 11 are provided is regarded as a resonator illustrated in Fig. 12, and the Q value is discussed in terms of a whole system including an outer space and the medium of the base material of the photonic crystal 21 (i.e., the semiconductor layer 13 constituting the photonic crystal 21). The following relational expression (Formula 3) is met where $Q_T$ is a Q value of the photoelectric transducer 10 as a whole, $Q_v$ is a Q value relating to coupling between the photonic crystal 21 and the outer space, $Q_{in}$ is a Q value relating to propagation in an in-plane direction of the photonic crystal 21, $Q_\alpha$ is a Q value relating to light absorption by the medium, and $Q_M$ is a Q value relating to light absorption by the rear surface metal electrode 11 (that is, an effect of attenuation absorption by the metal).

Note that $Q_\alpha$ is in proportion to a reciprocal of a light absorption coefficient $\alpha$ of the base material of the photonic crystal 21, as shown in Formula 4 below.

$$1/Q_T = 1/Q_v + 1/Q_{in} + 1/Q_\alpha + 1/Q_M \ \ldots \text{Formula 3}$$

$Q_v$ is in proportion to a reciprocal of a coefficient $\kappa_v$ indicative of strength of coupling between the photonic crystal 21 and the outer space (how easily coupling occurs), and indicates how easily the coupling between the photonic crystal 21 and the outer space causes light to be emitted to the outer space. Note that $Q_v$ can be calculated by use of Finite Difference Time Domain (FDTD) method, once the structure of the photonic crystal 21 is determined. That is, $Q_v$ is a Q value determined by the structure of the photonic crystal 21.

$Q_{in}$ indicates how easily light having entered the photonic crystal 21 propagates in a case where the light propagates in a horizontal direction. As such, in terms of optical confinement, $Q_{in}$ indicates how easily light leaks from the resonator instead of being confined. $Q_\alpha$ indicates the magnitude of an effect of resonance caused by light absorption by the medium. $Q_M$ indicates the magnitude of an effect of resonance caused by light absorption by the metal constituting the rear surface metal electrode 11. $Q_M$ can be obtained by measurement.

On the other hand, $Q_\alpha$ has a relation represented by the following Formula 4 with the coefficient of absorption $\alpha$ specific to the medium, a refractive index n of the medium, and a wavelength $\lambda$ of a resonance peak. That is, $Q_\alpha$ is a Q value determined by a material of the medium.

$$\alpha = 2\pi n/\lambda Q_\alpha \ \ldots \text{Formula 4}$$

When $Q_v = Q_\alpha$ in the relational expression of Formula 3, in other words, when $\kappa_v = \alpha a$, light absorption by the medium is at maximum and the wavelength band of the absorbed light is at maximum.

In a case where the resonance effect in the resonator is ideal and light does not leak into the plane of the optical semiconductor device, it is possible to assume $Q_{in} = \infty$.

From the above, the following Formula 5 is obtained.

$$Q_T = \pi \cdot n \cdot Q_M / (\lambda \cdot \alpha \cdot Q_M + \pi \cdot n) \ \ldots \text{Formula 5}$$

Now, the Q value ($Q_T$) of the photoelectric transducer 10 as a whole in which the photonic crystal 21 is designed so as to meet a relation $Q_v = Q_\alpha$ is calculated specifically by use of Formula 5. First, assuming the medium to be a-Si, the refractive index n of the medium is 4.154, and the coefficient of absorption $\alpha$ of the medium is 65,534 cm$^{-1}$. Furthermore, assuming that the wavelength $\lambda$ to be 660 nm and $Q_M$ of the metal to be 4000, $Q_T$ has a very small value below.

$$Q_T = 11.1$$

From Formula 1, $\Delta\lambda$ = 59.5nm, which is a very wide half bandwidth.

Therefore, by designing the photonic crystal 21 (designing the radius of each of the plurality of nanorods 19, the pitch a between the plurality of nanorods 19, etc.) so as to meet the relation $Q_v = Q_\alpha$, it is possible to (a) cause light having the wavelength $\lambda$ at the resonance peak, which wavelength $\lambda$ is defined by the band end B described above, to be easily absorbed by the medium and (b) obtain an effect of resonance in a wider wavelength range.

In other words, the photoelectric transducer of the present invention is a photoelectric transducer in which the photoelectric conversion layer includes a photonic crystal designed such that the Q value determined by the structure of the photonic crystal is equal to the Q value determined by the material of the medium of the photoelectric conversion layer in which the photonic crystal is formed.

The following description will additionally discuss a relation between the coefficient $\kappa_v$ and the coefficient of absorption $\alpha$a. First, since the photovoltaic material originally has a relatively light absorption ratio, $\alpha$a tends to be large and $Q_\alpha$ tends to be small in reverse.

On the other hand, in a case where a photonic crystal is provided in the photovoltaic material, providing the photonic crystal without any modification tends to result in a smaller coefficient $\kappa_v$ and, by contraries, a higher Qv. This is because the photovoltaic material generally has a refractive index higher by 1 or more than that of nanorods. Therefore, an unequal relation $\kappa_v \le \alpha$a ($Qv \ge Q_\alpha$) originally exists.

In order to increase the amount of light absorbed by the photovoltaic device, which is a goal to be achieved by the present invention, it is necessary that light coupled to the resonator constituted by the photonic crystal, in which the plurality of nanorods are provided periodically so as to form the band end B, is subjected to an absorption process by the photovoltaic device. This effect is maximized when $\kappa_v = \alpha$a ($Q_v = Q_\alpha$).

Given this, it is necessary to meet the relation $\kappa_v = \alpha$a ($Q_v = Q_\alpha$), in order to increase the amount of light absorbed by the photovoltaic device. In order to meet the relation $\kappa_v = \alpha$a ($Q_v = Q_\alpha$), it is necessary to make $\kappa_v$ larger (make Qv smaller). In order to make $\kappa_v$ larger (make Qv smaller), it is necessary to increase the ratio of coupling of the resonator as a whole (device as a whole) constituted by the photonic crystal (decrease the Q value of the photovoltaic device, i.e., $Q_T$ described above).

In addition, in a case where (a) the coefficient $\kappa_v$ and the coefficient of absorption $\alpha$a are substantially equal to each other and (b) the light absorption is carried out to a certain degree or more ($\alpha$a is about 5.0% or more), it is possible to broaden particularly a wavelength band (a band of resonance wavelengths) in which light absorption effect is high. This yields a significant effect of giving angle dependency and expanding the band of resonance wavelengths.

Consideration of the aforementioned mode coupling theory allows a more detailed discussion. Specifically, in a case where the thickness of a transparent layer corresponding to the transparent conductive film 12 in the photoelectric transducer 10 meets a relation $\theta2 = 2m\pi$ (m = 0, 1, 2 ...) with a phase difference $\theta2$ at the time of light reflection, Pv indicative of the ratio of optical energy absorbed by the optical semiconductor layer is represented by the following relational expression.

$$Pv = (8 \cdot Q_a / Qv) / (1 + 2Q_a / Q_M + 2Q_a / Qv)^2$$

As is known from the relational expression, in order to utilize 90% or more of light, it is desirable that the photonic crystalline structure be designed so as to meet a relation $0.2Q_v \le Q_\alpha \le 5.4Qv$.

(Modified example of photonic crystal)

Next, the following description will discuss a modified example of the photonic crystal.

Fig. 13 is a cross-sectional view illustrating a configuration of the photoelectric transducer 30 of the present invention.

The photoelectric transducer 30 has the same configuration as that of the photoelectric transducer 10, except that the photoelectric transducer 30 includes a photonic crystal 23 in place of the photonic crystal 21 in the photoelectric transducer 10.

The photonic crystal 23 has a different configuration from that of the photonic crystal 21 in that the height of each of the plurality of nanorods 39 is equal to the thickness of the semiconductor layer 13. The photonic crystal 23 is a cylindrical hole formed so as to pass through the semiconductor layer 13.

Note that shapes of a plurality of nanorods are not limited to cylindrical ones as those of the plurality of nanorods 19 and 39, and can be formed so as to have trapezoidal cross sections.

Fig. 14 is a cross-sectional view illustrating a configuration of a photonic crystal in which a plurality of nanorods, each of which has a trapezoidal cross section, are formed.

The photonic crystal 24 illustrated in Fig. 14 has a plurality of nanorods 49, which are formed in the semiconductor layer 13 and each of which has a trapezoidal cross section. Each of the plurality of nanorods 49 is formed so that an area of an upper surface of the each of the plurality of nanorods 49, which upper surface is formed on a surface of the semiconductor layer 13, is larger than an area of a lower surface of the each of the plurality of nanorods 49, which lower surface is formed inside the semiconductor layer 13.

That is, each of the plurality of nanorods 49 is a trapezoidal column whose upper surface, which is a surface on a light incidence surface side of the photoelectric transducer 30, has a n area larger than that of a lower surface of the trapezoidal column, which lower surface is on an opposite end side of the light incidence surface side.

This makes it possible to facilitate a processing carried out for forming the plurality of nanorods 49 in the semiconductor layer 13 by means of etching or the like.

Fig. 15 is a plan view illustrating a configuration of a photonic crystal in which a pitch between a plurality of nanorods differs among regions.

As illustrated in Fig. 15, a plurality of regions having respective different pitches for the plurality of nanorods can be provided in one photonic crystal.

As illustrated in Fig. 15, the photonic crystal 22 has, in the semiconductor layer 13, a region A1 in which the plurality of nanorods 19 are formed at a pitch a1, a region A2 in which the plurality of nanorods 19 are formed at a pitch a2, and a region A3 in which the plurality of nanorods 19 are formed at a pitch a3.

The pitch a1, the pitch a2, and the pitch a3 are fixed values which are different from one another and each of which is not less than 1/4 of the wavelength $\lambda$ nor more than the wavelength $\lambda$.

As illustrated in Fig. 15, the region A1, the region A2, and the region A3 are provided along a direction parallel to a side of the semiconductor layer 13 in plane view of the semiconductor layer 13 so that approximately 50 to 100 nanorods 19 arranged at an equal pitch are included in each of the region A1, the region A2, and the region A3.

This causes different band ends to be formed at respective points r in the region A1, the region A2, and the region A3. Accordingly, a wavelength $\lambda 1$, a wavelength $\lambda 2$, and a wavelength $\lambda 3$, which respectively correspond to a normalized frequency of the point r in the region A1, a normalized frequency of the point r in the region A2, and a normalized frequency of the point r in the region A3, are resonance wavelengths.

As described above, in the photonic crystal 22, it is possible to cause light having the wavelength $\lambda 1$, light having the wavelength $\lambda 2$, and light having the wavelength $\lambda 3$ can be respectively resonated in one photonic crystal 22. Accordingly, it is possible to improve the absorption ratio of a plurality of wavelengths by use of the respective regions A1, A2, and A3.

(Process for manufacturing photoelectric transducer)

Next, the following description will discuss a concrete example of a process for manufacturing the photoelectric transducer 10. Fig. 16 is a process drawing showing the process for manufacturing the photoelectric transducer 10.

First, as illustrated in (a) of Fig. 16, a transparent conductive film 17 is formed by depositing $SnO_2$ or the like on a glass 18, and a $SiO_2$ layer 81 is formed to have a thickness of 350 nm by depositing a material, such as $SiO_2$ to be the plurality of nanorods 19, on the transparent conductive film 17.

Next, as illustrated in (b) of Fig. 16, photoresist 82 is applied on the $SiO_2$ layer 81 so as to have a thickness of about 900 nm, and subsequently, patterns corresponding to positioning patterns of the plurality of nanorods 19 is drawn by exposure to an electron beam. In a case where the photoresist 82 is a positive photosensitive material, the exposed portion is removed by development, so that the positioning patterns of the plurality of nanorods 19 defined by the pitch a of about 150 nm to 250 nm and a diameter r of about 60 nm are formed.

Subsequently, as illustrated in (c) of Fig. 16, an Al film 83 is formed by depositing Al over the entire positioning patterns.

Then, as illustrated in (d) of Fig. 16, the photoresist 82 is removed so that the Al film 83 remains only at the portions where the plurality of nanorods 19 are formed. The step for removing the photoresist 82 causes a slight reduction in thickness of the $SiO_2$ layer 81 from 350 nm to about 330 nm.

Furthermore, as illustrated in (e) of Fig. 16, the remaining Al film 83 is used as a mask so as to remove unmasked $SiO_2$ with precision by means of Inductive Coupled Plasma-Reactive Ion Etching (ICP-RIE) employing carbon tetrafluoride ($CF_4$) as etching gas. Thus manufactured is an intermediate 90 in which the plurality of nanorods 19 are two-dimensionally arranged on the transparent conductive film 17.

Next, as illustrated in (f) of Fig. 16, the p-type semiconductor 16 is formed by depositing a-Si over an entire surface of the intermediate 90 and adding a p-type impurity to a-Si thus deposited. The i-type semiconductor 15 is formed by depositing a-Si on the p-type semiconductor 16. The n-type semiconductor 14 is formed by depositing a-Si on the i-type semiconductor and adding an n-type impurity to a-Si thus deposited.

Subsequently, the remaining Al film 83 is removed by wet etching using hydrochloric acid (HCl).

Lastly, as illustrated in (g) of Fig. 16, the transparent conductive film 12 is formed by depositing $SnO_2$ and the rear surface metal electrode 11 is laminated on the transparent conductive film 12. Thus completed is the photoelectric transducer 10.

[Embodiment 2]

The following description will discuss a second embodiment of a photoelectric transducer of the present invention, with reference to Fig. 17 and (a) and (b) of Fig. 18. For easy explanation, the like reference signs will be given to members each having the like function as a member as illustrated in the figures of Embodiment 1, and descriptions on such a member will be omitted.

Fig. 17 is a perspective view illustrating a configuration of a photoelectric transducer 50 in accordance with the present embodiment. (a) of Fig. 18 is a cross-sectional view illustrating a configuration of the photoelectric transducer 50 in accordance with the present embodiment. (b) of Fig. 18 is a cross-sectional view illustrating another example of a configuration of the photoelectric transducer 50 in accordance with the present embodiment.

The semiconductor layer 13 in the photoelectric transducer 10 described in Embodiment 1 has a configuration in which the n-type semiconductor 14, the i-type semiconductor 15, and the p-type semiconductor 16 are laminated. In contrast, a semiconductor layer 53 in the photoelectric transducer 50 in accordance with the present embodiment is a PIN semiconductor in which a p-type semiconductor 56, an i-type semiconductor 55, and an n-type semiconductor 54 are laterally bonded.

The photoelectric transducer 50 includes a reflecting layer 51 (metal layer), an insulating layer 52 laminated on the reflecting layer 51, the semiconductor layer 53 laminated on the insulating layer 52, an electrode 57a laminated on the semiconductor layer 53 along one edge part of the semiconductor layer 53, an electrode 57b laminated on the semiconductor layer 53 along the other edge part of the semiconductor layer 53, and a passivation film 58 laminated on the electrode 57a, the electrode 57b, and the semiconductor layer 53. The photonic crystal 25 is formed in the i-type semiconductor 55 in the semiconductor layer 53.

The passivation film 58 is one of two layers each made from a medium having a refractive index smaller than that of a medium of the semiconductor layer 53. The insulating layer 52 is the other of the two layers.

The reflecting layer 51 is provided on a rearmost surface side in the photoelectric transducer 50 and is made from a metal material, such as Mo and Al, having high reflectivity and a low absorption ratio.

The reflecting layer 51 is provided for reflecting, back to the semiconductor layer 53, light having been transmitted through the semiconductor layer 53 out of light having entered the photoelectric transducer 50 from an incidence surface side thereof. As such, the reflecting layer 51 preferably covers the entire rear surface of the semiconductor layer 53.

The insulating layer 52 is made from, for example, the same material as that of the passivation film 58.

The semiconductor layer 53 is constituted by the n-type semiconductor 54, the i-type semiconductor 55, and the p-type semiconductor 56, which are formed in the same layer. The n-type semiconductor 54, the i-type semiconductor 55, and the p-type semiconductor 56 are each made from a-Si. The n-type semiconductor 54 and the p-type semiconductor 56 are each bonded to the i-type semiconductor 55. That is, the n-type semiconductor 54 and the p-type semiconductor 56 are provided in a layer above the insulating layer 52, with the i-type semiconductor 55 interposed between the n-type semiconductor 54 and the p-type semiconductor 56.

A plurality of nanorods 59 are formed in the i-type semiconductor 55 in a regular manner. In the present embodiment, the i-type semiconductor 55 serves as a photonic crystal 25.

Since the electrodes 57a and 57b for extracting electric power are laminated on the p-type semiconductor 56 and the n-type semiconductor 54, respectively, an upper surface of the i-type semiconductor 55 serves as a light-receiving surface. Therefore, in a case where at least the passivation film 58 is designed to be transparent out of the passivation film 58 and the insulating layer 52 sandwiching the i-type semiconductor 55 in which the photonic crystal 25 is formed, it is possible to take light into the photonic crystal.

The plurality of nanorods 59 are formed, in a hexagonal lattice constituted by a triangular lattice, over the entire surface of the i-type semiconductor 55. Similarly with the photonic crystal 21, a pitch a between the plurality of nanorods 59 is 1/4 to 1/1 of a wavelength (wavelength at a resonance peak) $\lambda$ (nm) which is strongly resonated inside the photonic crystal 21.

Each of the plurality of nanorods 59 has a height not more than 1/4 of a thickness of the i-type semiconductor 55. As illustrated in (b) of Fig. 18, the height of the each of the plurality of nanorods 59 can be equal to the thickness of the i-type semiconductor 55.

The electrode 57a and the electrode 57b are electrodes for extracting, to the outside, an electric current generated by photoelectric conversion carried out in the semiconductor layer 53. The electrode 57a is formed so as to be laminated on the p-type semiconductor 56, and the electrode 57b is formed so as to be laminated on the n-type semiconductor 54. As such, an electric charge mainly generated by means of photoexcitation in the i-type semiconductor 55 becomes an electric current flowing through a circuit constituted by the electrode 57a on the p-type semiconductor 56, the electrode 57b on the n-type semiconductor 54, and an external resistor. The electric current causes electromotive force at the external resistor.

The passivation film 58 is made from a material having a refractive index n of about 1.2 to 2.0, and constituted by a dielectric having a refractive index lower than that of the medium (e.g., a-Si) of the semiconductor layer 13. The passivation film 58 can be made from an inorganic insulating material such as $SiO_2$ and SiNx, and covers the semiconductor layer 13 and the electrode 57a and the electrode 57b which are laminated on the semiconductor layer 13.

As described above, the semiconductor layer 53 has a p-i-n lateral structure, instead of the p-I-n vertical structure as illustrated in Fig. 1. That is, the semiconductor layer 53 has a structure in which the p-type semiconductor 56, the i-type semiconductor 55, and the n-type semiconductor 54 are laterally arranged in this order so as to be adjacent to each other.

The lateral structure is advantageous for reducing the thickness of the photoelectric transducer. Another advantage of the lateral structure is an increased sensing speed (photoresponse speed) as compared with the vertical structure, due to less overlapping between layers and a consequent reduction parasitic capacitance between the layers as compared with the vertical structure.

Furthermore, according to the configuration of the photoelectric transducer 50, a similar effect can be attained as that of the photoelectric transducer 10.

[Embodiment 3]

The following description will discuss a third embodiment of a photoelectric transducer of the present invention, with reference to Fig. 19 and (a) and (b) of Fig. 20. For easy explanation, the like reference signs will be given to members each having the like function as a member as illustrated in the figures of Embodiments 1 and 2, and descriptions on such a member will be omitted.

Fig. 19 is a perspective view illustrating a configuration of a photoelectric transducer 60 in accordance with the present embodiment. (a) of Fig. 20 is a cross-sectional view illustrating a configuration of the photoelectric transducer 60 in accordance with the present embodiment. (b) of Fig. 20 is a cross-sectional view illustrating another example of a configuration of the photoelectric transducer 60 in accordance with the present embodiment.

The photoelectric transducer 60 in accordance with the present embodiment has an n-i-n structure in which an n-type semiconductor 64a and an n-type semiconductor 64b are laminated on a rectangular i-type semiconductor 65 respectively at both edge parts, which are opposite to each other, of the i-type semiconductor 65. A semiconductor layer 63 is constituted by the i-type semiconductor 65, the n-type semiconductor 64a, and the n-type semiconductor 64b.

A transparent electrode 67a and a transparent electrode 67b, each made from ITO, are laminated respectively on the n-type semiconductor 64a and the n-type semiconductor 64b. An electrode 57a and an electrode 57b, each made from a metal material, are laminated respectively on the transparent electrode 67a and the transparent electrode 67b. Each of the n-type semiconductors 64a and 64b is made from a-Si. A passivation film 58 is formed so as to cover the semiconductor layer 63, and the electrode 57a and the electrode 57b which are provided on the semiconductor layer 63.

As described above, the photoelectric transducer 60 has the n-i-n structure in which the n-type semiconductors 64a and 64b are laminated on the rectangular i-type semiconductor 65 respectively at the both edge parts, opposed to each other, of the i-type semiconductor 65. That is, the photoelectric transducer 60 has the same structure as that of a TFT employing a-Si as a semiconductor layer. Since the electrodes for extracting electric power are laminated respectively on the n-type semiconductor 64a and 64b at the both edge parts, a central part of the i-type semiconductor 65 where the n-type semiconductors 64a and 64b are not provided serves as a light-receiving surface. In the photoelectric transducer 60, a photonic crystal 25 constituted by the plurality of nanorods 59 is formed in the central part.

The pitch etc. of the plurality of nanorods 59 is the same as those described in Embodiments 1 and 2.

By employing a two-layered structure constituted by (a) the transparent electrode 67a and the transparent electrode 67b and (b) the electrode 57a and the electrode 57b, it is possible to prevent migration of the electrode 57a and the electrode 57b from reducing insulation resistance between the electrode 57a and the electrode 57b and to reduce resistance of the electrode 57a and the electrode 57b as a whole.

On the rear surface side of the i-type semiconductor 65, an insulating layer (called GI layer, AO layer, etc.) 52 serving similarly with a gate insulating film of a TFT is provided, and a rear surface metal electrode 11 serving similarly with a gate electrode of a TFT covers the rear surface of the insulating layer 52. The rear surface metal electrode 11 can be made of Ti, Al, etc.

In the configuration, an electric charge mainly generated by photoexcitation at i-type semiconductor 65 becomes electric current that flows in a circuit constituted by the electrode 57a and the electrode 57b, which are provided on both sides of the i-type semiconductor 65, and an external resistor, thereby generating electromotive force at the external resistor.

In a case of providing a photonic crystal in an optical sensor whose phototransistor is an inversely staggered TFT (Thin Film Transistor), the photonic crystal should be provided in a semiconductor layer so as to be at a portion located above a gate electrode. Light having reached the gate electrode out of light incident to the TFT is reflected by the gate electrode and travels back to the photonic crystal. By including the light that has traveled back, it is possible to enhance the photoelectromotive force of the sensor.

As illustrated in (a) of Fig. 20, the plurality of nanorods 59 are formed so as to have a thickness not more than a thickness of the i-type semiconductor 65. Note that, as illustrated in (b) of Fig. 20, the height of the plurality of nanorods 59 can be equal to the thickness of the i-type semiconductor 65.

[Embodiment 4]

The following description will discuss a fourth embodiment of a photoelectric transducer of the present invention, with reference to Fig. 21. For easy explanation, the like reference signs will be given to members each having the like function as a member as illustrated in the figures of Embodiments 1 through 3, and descriptions on such a member will be omitted.

Fig. 21 is a cross-sectional view illustrating a configuration of a photoelectric transducer 70 in accordance with the present embodiment.

The photoelectric transducer 70 includes a semiconductor layer 73 constituted by an n-type semiconductor 74, an i-type semiconductor 75, and a p-type semiconductor 76 which are laminated in this order from the rear surface side. The n-type semiconductor 74, the i-type semiconductor 75, and the p-type semiconductor 76 respectively have a plurality of protrusions 79c, a plurality of protrusions 79b, and a plurality of protrusions 79a. The positions of the protrusions 79c, the positions of the protrusions 79b, and the positions of the protrusions 79a correspond to one another. The protrusions 79c, the protrusions 79b, and the protrusions 79a laminated corresponding to one another constitute nanorods 79.

A photonic crystal 27 is constituted by the nanorods 79 formed in the semiconductor layer 73.

The nanorods 79 can be constituted by (a) the protrusions 79c, the protrusions 79b, and the protrusions 79a respectively provided in the n-type semiconductor 74, the i-type semiconductor 75, and the p-type semiconductor 76 (as in the photoelectric transducer 70) or (b) the protrusions provided in any one of the layers of the n-type semiconductor 74, the i-type semiconductor 75, and the p-type semiconductor 76. In the case of providing the protrusions in any one of the layers of the n-type semiconductor 74, the i-type semiconductor 75, and the p-type semiconductor 76, photoelectric conversion mainly occurs within the i-type semiconductor 75. It is therefore preferable in this case to provide the protrusions at an interface between the n-type semiconductor 74 and the i-type semiconductor 75 or at an interface between the i-type semiconductor 75 and the p-type semiconductor 76.

A pitch, radius, etc. of the nanorods 79 are the same as those described in Embodiments 1 through 3.

That is, the nanorods 79 are arranged two-dimensionally and periodically at a pitch not less than 1/4 of $\lambda$ nor more than $\lambda$ where $\lambda$ is a wavelength at a resonance peak of the photonic crystal 27.

Furthermore, the photoelectric crystal 27 satisfies the following formula:

$$0.2Q_v \leq Q_a \leq 5.4Q_v$$

where $Q_v$ is (a) a Q value which indicates a magnitude of an effect of resonance caused by coupling between the photonic crystal 27 and an external world and (b) in proportion to a reciprocal of a coefficient $\kappa_v$ indicating a strength of the coupling between the photonic crystal and the external world, and $Q_a$ is (a) a Q value which indicates a magnitude of an effect of resonance caused by the medium of the photoelectric conversion layer and (b) in proportion to a reciprocal of a coefficient $\alpha a$ of light absorption by the medium of the semiconductor layer 73.

A glass substrate 78 has a plurality of concave parts which are formed by etching or the like in the areas where the nanorods 79 are provided. The concave parts are provided on the rear surface of the glass substrate 78 so that (a) a distance between adjacent concave parts is equal to the pitch a and (b) the concave parts are in a hexagonal lattice constituted by a triangular lattice.

On the surface of the glass substrate 78 on which the concave parts are provided, a transparent conductive film 77 which is TCO, the p-type semiconductor 76 made from a-Si, the i-type semiconductor 75 made from a-Si, the n-type semiconductor 74 made from a-Si, a transparent conductive film 72 which is TCO, and a rear surface metal electrode 71 (metal layer) are laminated in this order. This causes uneven parts, corresponding to the concave parts provided in the glass substrate 78, to be formed in each of the layers laminated on the glass substrate 78.

This allows the photoelectric transducer 70 to have the same effect as those of the photoelectric transducers 10, 30, 50, and 60.

The present invention is not limited to the above-described embodiments but allows various modifications within the scope of the claims. Any embodiment derived from an appropriate combination of the technical means disclosed in the different embodiments will also be included in the technical scope of the present invention.

As described above, a photoelectric transducer of the present invention includes: a photoelectric conversion layer; and a photonic crystal formed inside the photoelectric conversion layer, the photonic crystal being formed by providing a plurality of columnar media inside the photoelectric conversion layer, each of the plurality of columnar media having a refractive index lower than that of a medium of the photoelectric conversion layer, the plurality of columnar media being provided two-dimensionally and periodically at a pitch of not less than $\lambda/4$ nor more than $\lambda$, where $\lambda$ is a wavelength of a peak of resonance caused by the photonic crystal, the photoelectric transducer satisfying the following formula:

$$0.2Q_V \leq Q_\alpha \leq 5.4Q_V$$

where $Q_V$ is (a) a Q value which indicates a magnitude of an effect of resonance caused by coupling between the photonic crystal and an external world and (b) in proportion to a reciprocal of a coefficient $\kappa_V$ indicating a strength of the coupling between the photonic crystal and the external world, and $Q_a$ is (a) a Q value which indicates a magnitude of an effect of resonance caused by the medium of the photoelectric conversion layer and (b) in proportion to a reciprocal of a coefficient of light absorption by the medium of the photoelectric conversion layer.

According to the configuration, the photonic crystal is provided inside the photoelectric conversion layer. This allows light having entered the photoelectric conversion layer to be resonated by the photonic crystal.

In the photonic crystal, the plurality of columnar media are two-dimensionally arranged at the pitch of not less than $\lambda/4$ nor more than $\lambda$. This causes a band end to be formed at a point r in of a reciprocal space the photonic crystal. A wavelength of light defined by the band end becomes $\lambda$.

This makes it possible to (a) confine, within the photoelectric conversion layer in which the photonic crystal is provided, incident light entering the photoelectric conversion layer in a direction perpendicular to the photoelectric conversion layer and having the wavelength $\lambda$ out of light entering the photoelectric conversion layer and (b) cause the confined light to be resonated. The light having the resonance peak wavelength $\lambda$ and having been resonated with angle dependency in the photoelectric conversion layer is absorbed by the medium of the photoelectric conversion layer.

Here, in a case where the coefficient $\kappa_V$ is substantially equal to the coefficient of absorption, in other words, in a case where $Q_V$ and $Q_\alpha$ are substantially equal to each other, light absorption by the medium of the photoelectric conversion layer is at maximum, and the wavelength band of the absorbed light is at maximum.

Note that, even if $Q_V$ and $Q_\alpha$ are not substantially equal to each other, in a case as above where the condition $0.2Q_V \leq Q_\alpha \leq 5.4Q_V$ is met, the effect of light absorption by the photonic crystal is enhanced.

Therefore, the configuration allows increasing the light absorption ratio of the photoelectric transducer having a photonic crystalline structure, and consequently allows increasing photoelectromotive force at the aforementioned band approximately between 520 nm to 820 nm in wavelength. Furthermore, by matching the wavelength of a resonance peak defined by the band end with a wavelength band at which the ratio of absorption by the medium of photoelectric conversion layer is low, the photoelectric transducer can absorb light in a wider wavelength band.

In the photoelectric transducer of the present invention, it is preferable that, in the photonic crystal, the plurality of columnar media be provided at respective apices of a triangle or of a square in a plan view of the photonic crystal the photonic crystal.

This allows the photonic crystal to be designed such that the band end is provided at the point $\Gamma$ in the reciprocal space, and the wavelength of light defined by the band end becomes $\lambda$. Accordingly, by causing light having the wavelength $\lambda$ to be resonated inside the photoelectric transducer, the light absorption can be increased.

In the photoelectric transducer of the present invention, it is preferable that, in the photonic crystal, the plurality of columnar media be provided periodically in the medium of the photoelectric conversion layer so as to have a height of not more than 1/4 of a thickness of the photoelectric conversion layer.

With the configuration, the plurality of columnar media provided in the photoelectric conversion layer are shorter than the photoelectric conversion layer. This makes it easier to form the plurality of columnar media in the photoelectric conversion layer. That is, the configuration facilitates the formation of the photonic crystal.

In the photoelectric transducer of the present invention, it is preferable that, in the photonic crystal, the plurality of columnar media are provided periodically in the medium of the photoelectric conversion layer so as to have a height equal to a thickness of the photoelectric conversion layer.

This configuration is an example of a configuration of a photonic crystal that can be manufactured relatively easily by a publicly known semiconductor process technique.

In the photoelectric transducer of the present invention, it is preferable that the photonic crystal have (a) a first region in which the plurality of columnar media are provided two-dimensionally at a constant pitch and (b) a second region in which the plurality of columnar media are provided two-dimensionally at a constant pitch that is different from the constant pitch in the first region.

As in this configuration, by designing the fixed pitch, at which the plurality of columnar media are provided, to be different between the regions, the resonance peak wavelength defined by the band end formed by the photonic crystal can be made different between the regions. This allows a plurality of wavelengths at peaks of resonance caused by the photonic crystal to appear in the respective regions, thereby further improving the light absorption ratio.

The photoelectric transducer of the present invention the photoelectric conversion layer further includes two layers sandwiching the photoelectric conversion layer therebetween, each of the two layers being made from a medium having a refractive index lower than that of the medium of the photoelectric conversion layer, at least one of the two layers being transparent.

According to the configuration light that is propagated in a direction perpendicular to the surfaces of the photoelectric conversion layer and would leak therefrom can be confined based on the same principle as that of an optical fiber in which a core with a high refractive index is covered with a clad with a low refractive index. Consequently, the light absorption ratio of the photoelectric conversion layer can be further increased.

Note that, in order to cause light to enter the photonic crystal, at least one of the two layers which is provided closer to the light-receiving surface of the photoelectric transducer should be transparent.

In the photoelectric transducer of the present invention, the photoelectric conversion layer has a structure in which a plurality of layers are provided adjacent to each other, the structure being (a) a vertical structure in which the plurality of layers are vertically laminated or (b) a lateral structure in which the plurality of layers are laterally arranged, the plurality of layers being (a) a p-type semiconductor layer, an intrinsic semiconductor layer, and an n-type semiconductor layer or (b) an n-type semiconductor layer, an intrinsic semiconductor layer, and another n-type semiconductor layer.

The photoelectric transducer having a structure in which a p-type semiconductor layer, an intrinsic semiconductor layer, and an n-type semiconductor layer are provided adjacent to each other is a photoelectric transducer called PIN photoelectric transducer. The photoelectric transducer having a structure in which an n-type semiconductor layer, an intrinsic semiconductor layer, and another n-type semiconductor layer are provided adjacent to each other is a photoelectric transducer called NIN photoelectric transducer.

In the PIN photoelectric transducer and the NIN photoelectric transducer, an electron and a hole are generated in the intrinsic semiconductor layer, so that an electric current can be extracted efficiently. Therefore, the PIN photoelectric transducer and the NIN photoelectric transducer are suitable for use in solar cells or optical sensors.

Furthermore, the vertical structure is advantageous for reducing an area occupied by the photoelectric transducer, and the lateral structure is advantageous for thinning the photoelectric transducer. In addition, the lateral structure has a merit of higher sensing speed (photoresponse speed) than that of the vertical structure, since the lateral structure has less overlapping between layers as compared with the vertical structure and consequently smaller parasitic capacitance between the layers.

The photoelectric transducer of the present invention further includes a metal layer in an outermost layer of the photoelectric transducer on a side opposite to a side from which light enters the photoelectric transducer, the metal layer covering an entire surface of the photoelectric transducer on the side from which the light enters the photoelectric transducer.

With this configuration, since the metal layer reflects light having been transmitted through the photoelectric conversion layer and the like so that the light travels back to the photoelectric conversion layer, the photoelectric conversion ratio can be increased. Furthermore, the metal layer can also serve as an electrode for extracting an electric current.

In the photoelectric transducer of the present invention, each of the plurality of columnar media has a trapezoidal shape so that an area of an upper surface of the each of the plurality of columnar media, which upper surface is on a side of a light incident surface of the photoelectric transducer, is larger than an area of a lower surface of the each of the plurality of columnar media, which lower surface is on a side opposite to the side of the light incident surface.

This makes it possible to facilitate a processing carried out when the columnar medium is formed by means of etching or the like.

Note that it is not an essential requirement to form the photonic crystal throughout the photoelectric conversion layer in the present invention. Formation of the photonic crystal at a part of the photoelectric conversion layer allows increasing the photoelectric conversion ratio than a conventional photoelectric transducer. In this case, it is preferable that the metal layer be provided at the whole of a lower region corresponding to the part where the photonic crystal is provided.

A photoelectric transducer of the present invention includes: a photoelectric conversion layer including a plurality of semiconductors being laminated; and a photonic crystal formed inside the photoelectric conversion layer, at least one of the plurality of semiconductors having a plurality of protrusions, the photonic crystal including the at least one of the plurality of semiconductors which has the plurality of protrusions, the plurality of protrusions being provided two-dimensionally and periodically at a pitch of not less than λ/4 nor more than λ, where λ is a wavelength of a peak of resonance caused by the photonic crystal, the photoelectric transducer satisfying the following formula:

$$0.2Q_V \leq Q_\alpha \leq 5.4Q_V$$

where Qv is (a) a Q value which indicates a magnitude of an effect of resonance caused by coupling between the photonic crystal and an external world and (b) in proportion to a reciprocal of a coefficient $\kappa_V$ indicating a strength of the coupling between the photonic crystal and the external world, and Qa is (a) a Q value which indicates a magnitude of an effect of resonance caused by the medium of the photoelectric conversion layer and (b) in proportion to a reciprocal of a coefficient of light absorption by the medium of the photoelectric conversion layer.

As in this configuration, a photonic crystal can be constituted by forming a plurality of protrusions in a semiconductor layer. In the photonic crystal thus formed, the plurality of protrusions are arranged two-dimensionally and periodically at a pitch of not less than λ/4 nor more than λ, so that a band end is formed in a point r direction. This makes it possible to (a) confine, within the photoelectric conversion layer, incident light entering the photoelectric conversion layer in a direction perpendicular to the photoelectric conversion layer and having the wavelength λ out of light entering the photoelectric conversion layer and (b) cause the confined light to be resonated. The light having the resonance peak wavelength λ and having been resonated in the photoelectric conversion layer is absorbed by the medium of the photoelectric conversion layer.

In a case where the coefficient $\kappa_V$ and the coefficient of absorption are substantially equal to each other, in other words, in a case where $Q_V$ and $Q_\alpha$ are substantially equal to each other, the absorption of light by the medium of the photoelectric conversion layer is at maximum, and the wavelength band of the absorbed light is at maximum.

Note that, even if $Q_V$ and $Q_\alpha$ are not substantially equal to each other, in a case where the condition $0.2Q_V \leq Q_\alpha \leq 5.4Qv$ is met as described above, the effect of absorption of light by the photonic crystal is enhanced.

Therefore, the configuration allows increasing the light absorption ratio of the photoelectric transducer having a photonic crystalline structure, and consequently allows increasing photoelectromotive force at the aforementioned band approximately between 520 nm to 820 nm in wavelength. Furthermore, by matching the wavelength of a resonance peak defined by the band end with a wavelength band at which the ratio of absorption by the medium of the photoelectric conversion layer is low, the photoelectric transducer can absorb light in a wider wavelength band.

It should be noted that a combination of configurations recited in individual claims is not limited to a combination of one claim with a claim depending from the claim. Any combination of configurations is possible between one claim and another claim that is not dependent from the claim provided that the object of the present invention can be achieved by the combination.

Industrial Applicability

The present invention can be applied to photoelectric transducers in general and is particularly suitable for a photoelectric transducer of a solar cell or of an optical sensor.

Reference Signs List

10, 30, 50, 60, and 70: photoelectric transducer
11 and 71: rear surface metal electrode (metal layer)
12: transparent conductive film (one of two layers)
17: transparent conductive film (the other of two layers)
13, 53, 63, and 73: semiconductor layer (photoelectric conversion layer)
14, 54, 64a, and 74: n-type semiconductor
15, 55, 65, and 75: i-type semiconductor
16, 56, and 76: p-type semiconductor
18: glass
19, 39, 49, 59, and 79: nanorod (columnar medium)
21, 22, 23, 24, 25, and 27: photonic crystal
51: reflecting layer (metal layer)

52: insulating layer
58: passivation film (one of two layers)
a, a1, a2, and a3: pitch
A1, A2, and A3: region

**Claims**

1.  A photoelectric transducer comprising:

    a photoelectric conversion layer; and
    a photonic crystal formed inside the photoelectric conversion layer,
    the photonic crystal being formed by providing a plurality of columnar media inside the photoelectric conversion layer, each of the plurality of columnar media having a refractive index lower than that of a medium of the photoelectric conversion layer,
    the plurality of columnar media being provided two-dimensionally and periodically at a pitch of not less than $\lambda/4$ nor more than $\lambda$, where $\lambda$ is a wavelength of a peak of resonance caused by the photonic crystal,
    the photoelectric transducer satisfying the following formula:

    $$0.2Q_v \leq Q_a \leq 5.4Q_v$$

    where $Q_v$ is (a) a Q value which indicates a magnitude of an effect of resonance caused by coupling between the photonic crystal and an external world and (b) in proportion to a reciprocal of a coefficient $\kappa_V$ indicating a strength of the coupling between the photonic crystal and the external world, and $Q_a$ is (a) a Q value which indicates a magnitude of an effect of resonance caused by the medium of the photoelectric conversion layer and (b) in proportion to a reciprocal of a coefficient of light absorption by the medium of the photoelectric conversion layer.

2.  The photoelectric transducer as set forth in claim 1, wherein:

    in the photonic crystal, the plurality of columnar media are provided at respective apices of a triangle in a plan view of the photonic crystal.

3.  The photoelectric transducer as set forth in claim 1, wherein:
    in the photonic crystal, the plurality of columnar media are provided at respective apices of a square in a plan view of the photonic crystal.

4.  The photoelectric transducer as set forth in any one of claims 1 through 3, wherein:

    in the photonic crystal, the plurality of columnar media are provided periodically in the medium of the photoelectric conversion layer so as to have a height of not more than 1/4 of a thickness of the photoelectric conversion layer.

5.  The photoelectric transducer as set forth in any one of claims 1 through 3, wherein:
    in the photonic crystal, the plurality of columnar media are provided periodically in the medium of the photoelectric conversion layer so as to have a height equal to a thickness of the photoelectric conversion layer.

6.  The photoelectric transducer as set forth in any one of claims 1 through 5, wherein:

    the photonic crystal has (a) a first region in which the plurality of columnar media are provided two-dimensionally at a constant pitch and (b) a second region in which the plurality of columnar media are provided two-dimensionally at a constant pitch that is different from the constant pitch in the first region.

7.  A photoelectric transducer as set forth in any one of claims 1 through 6, further comprising two layers sandwiching the photoelectric conversion layer therebetween,
    each of the two layers being made from a medium having a refractive index lower than that of the medium of the photoelectric conversion layer, at least one of the two layers being transparent.

8. The photoelectric transducer as set forth in any one of claims 1 through 7, wherein:

the photoelectric conversion layer has a structure in which a plurality of layers are provided adjacent to each other, the structure being (a) a vertical structure in which the plurality of layers are vertically laminated or (b) a lateral structure in which the plurality of layers are laterally arranged,
the plurality of layers being (a) a p-type semiconductor layer, an intrinsic semiconductor layer, and an n-type semiconductor layer or (b) an n-type semiconductor layer, an intrinsic semiconductor layer, and another n-type semiconductor layer.

9. A photoelectric transducer as set forth in any one of claims 1 through 8, further comprising a metal layer in an outermost layer of the photoelectric transducer on a side opposite to a side from which light enters the photoelectric transducer, the metal layer covering an entire surface of the photoelectric transducer on the side from which the light enters the photoelectric transducer.

10. The photoelectric transducer as set forth in any one of claims 1 through 9, wherein:

each of the plurality of columnar media has a trapezoidal shape so that an area of an upper surface of the each of the plurality of columnar media, which upper surface is on a side of a light incident surface of the photoelectric transducer, is larger than an area of a lower surface of the each of the plurality of columnar media, which lower surface is on a side opposite to the side of the light incident surface.

11. A photoelectric transducer comprising:

a photoelectric conversion layer including a plurality of semiconductors being laminated; and
a photonic crystal formed inside the photoelectric conversion layer,
at least one of the plurality of semiconductors having a plurality of protrusions,
the photonic crystal including the at least one of the plurality of semiconductors which has the plurality of protrusions,
the plurality of protrusions being provided two-dimensionally and periodically at a pitch of not less than $\lambda/4$ nor more than $\lambda$, where $\lambda$ is a wavelength of a peak of resonance caused by the photonic crystal,
the photoelectric transducer satisfying the following formula:

$$0.2Q_v \le Q_a \le 5.4Q_v$$

where $Q_v$ is (a) a Q value which indicates a magnitude of an effect of resonance caused by coupling between the photonic crystal and an external world and (b) in proportion to a reciprocal of a coefficient $\kappa_V$ indicating a strength of the coupling between the photonic crystal and the external world, and $Q_a$ is (a) a Q value which indicates a magnitude of an effect of resonance caused by the medium of the photoelectric conversion layer and (b) in proportion to a reciprocal of a coefficient of light absorption by the medium of the photoelectric conversion layer.

FIG. 1

FIG. 2

F I G. 3

F I G. 4

F I G. 5

FIG. 6

FIG. 7

a/λ (NORMALIZED FREQUENCY)

F I G. 8

ABSORPTION RATIO OF a-Si
(BASED ON MEASUREMENT: 330 nm IN THICKNESS)

F I G. 9

FIG. 10

FIG. 11

EASINESS $\kappa_v$ IN COUPLING WITH OUTSIDE
(EXPRESSED IN Q VALUE: $1/Q_v$)

ABSORPTION $\alpha$a BY PHOTOVOLTAIC MATERIAL
(EXPRESSED IN Q VALUE: $1/Q_\alpha$)

RATIO $\kappa_{in}$ OF PROPAGATION IN PLANE
(EXPRESSED IN Q VALUE: $1/Q_{in}$)

F I G. 1 2

COUPLING $\kappa_v$ WITH OUTER SPACE
(EXPRESSED IN Q VALUE: $1/Q_v$)

RESONATOR

ABSORPTION $\alpha$a BY PHOTOVOLTAIC MATERIAL
(EXPRESSED IN Q VALUE: $1/Q_\alpha$)

FIG. 13

FIG. 14

FIG. 15

EP 2 523 219 A1

FIG. 16

(a)

350nm — SiO₂ — 81
17
18

↑ DIRECTION IN
WHICH LIGHT
IS INCIDENT

(b)

900nm — 82
350nm — SiO₂ — 81
17
18

(c)

300nm — 83
900nm — 82
350nm — SiO₂ — 81
17
18

(d)

300nm — 83
330nm — SiO₂ — 81
17
18

(e)

90
300nm — 83
330nm — SiO₂ — 19
17
18

(f)

ETCHING OF Al BY HCl

330nm — SiO₂ — 14
15
16
17
18

(g)

10
11
12
14
SiO₂ — 15
16
17
18

↑ DIRECTION IN
WHICH LIGHT
IS INCIDENT

F I G.  1 7

F I G.  1 8

(a)

(b)

F I G. 1 9

FIG. 20

(a)

(b)

FIG. 21

FIG. 22

F I G. 2 3

F I G. 2 4

(a)　　　　　　　　(b)　　　　　　　　(c)

LIGHT

200

203

<div align="center">

**INTERNATIONAL SEARCH REPORT**

</div>

| | International application No. |
|---|---|
| | PCT/JP2010/072807 |

**A. CLASSIFICATION OF SUBJECT MATTER**
*H01L31/04*(2006.01)i, *H01L31/10*(2006.01)i

According to International Patent Classification (IPC) or to both national classification and IPC

**B. FIELDS SEARCHED**

Minimum documentation searched (classification system followed by classification symbols)
H01L31/04-31/078, H01L31/10

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| A | JP 2008-124230 A (Kaneka Corp.), 29 May 2008 (29.05.2008), claims 1 to 4; paragraphs [0018] to [0057]; fig. 1 to 2 (Family: none) | 1-11 |
| A | JP 2009-533875 A (Massachusetts Institute of Technology), 07 December 2009 (07.12.2009), paragraphs [0010] to [0023]; fig. 2 to 4 & US 2007/0235072 A1  & EP 2018668 A & WO 2007/121082 A2 | 1-11 |
| A | O. El Daif et al., Photonic band-engineering absorption enhancement of amorphous silicon for solar cells, PROC. OF SPIE, 2009.08.20, Vol. 7411, 74110O-1-8 | 1-11 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 March, 2011 (15.03.11) | 29 March, 2011 (29.03.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/072807 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | D. Zhou et al., Photonic crystal enhanced light-trapping in thin film solar cells, JOURNAL OF APPLIED PHYSICS, 2008.05.01, Vol.103, pp. 093102-1-5 | 1-11 |
| P,A | Hiroaki SHIGETA et al., "Hikari Kidenryoku Soshi no Koden Henkan Koritsu Zodai ni Muketa Photonic Kessho Kyoshin Sayo no Saitekika", Dai 57 Kai Extended Abstracts, Japan Society of Applied Physics and Related Societies, 03 March 2010 (03.03.2010), lecture no.19p-M-14 | 1-11 |
| P,A | G. Gomard et al., Two-dimensional photonic crystal for absorption enhancement in hydrogenated amorphous silicon thin film solar cells, JOURNAL OF APPLIED PHYSICS, 2010.12.16, Vol.108, pp. 123102-1-8 | 1-11 |
| P,A | P. A. Postigo et al., Enhancement of solar cell efficiency using two-dimensional photonic crystals, PROC. OF SPIE, 2010.05.11, Vol. 7713, pp. 771307-1-7 | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009533875A PCT
- JP 2006024495 A
- JP 2006032787 A
- WO 2007108212 A

**Non-patent literature cited in the description**

- **C.MANOLATOU ; M.J.KHAN ; SHANHUIFAN ; PIERRE R.VILLENEUVE ; H.A.HAUS ; LIFE FELLOW ; J.D.JOANNOPOULOS.** Coupling of Modes Analysis of Resonant Channel Add-Drop Filters. *IEEE JOUNAL OF QUANTUM ELECTRONICS,* September 1999, vol. 35 (9), 1322-1331
- **J.R.TUMBLESTON ; DOO-HYUN KO ; EDWARD T.SAMULSKI ; RENE LOPEZ.** Absorption and quasiguided mode analysis of organic solar cells with photonic crystal photoactive layers. *OPTICS EXPRESS/Optical Society of America,* 27 April 2009, vol. 17 (9), 7670-7681